# EUROPEAN PATENT APPLICATION

(11) **EP 4 675 687 A1**
(43) Date of publication of application: **07.01.2026**
(21) Application number: 24763576.6
(22) Date of filing: 09.02.2024
(51) Int. Cl.: H01L 31/107, H01L 27/146

(54) **PHOTOELECTRIC CONVERSION DEVICE**

(30) Priority: 27.02.2023 JP 2023028686; 15.12.2023 JP 2023211925
(71) Applicant: Canon Kabushiki Kaisha, Tokyo, 146-8501 (JP)
(72) Inventor: EHARA Alice, Tokyo 146-8501 (JP); MORIMOTO Kazuhiro, Tokyo 146-8501 (JP); SEKINE Hiroshi, Tokyo 146-8501 (JP)
(74) Representative: Canon Europe Limited
(86) International application number: PCT/JP2024/004490
(87) International publication number: WO 2024/181092

(57) **Abstract**

A photoelectric conversion device includes a semiconductor layer having a first surface and a second surface facing the first surface. The semiconductor layer includes a plurality of avalanche photodiodes (APDs). The plurality of APDs include a first APD and a second APD. The first APD and the second APD each include a first semiconductor region of a first conductivity type and a second semiconductor region of a second conductivity type. The first semiconductor region and the second semiconductor region are arranged in this order from a second surface side. A PN bonding portion is formed between the first semiconductor region and the second semiconductor region. A first isolation portion and a second isolation portion are provided between the first APD and the second APD. The first isolation portion is formed from the second surface side, and a light absorbing material is embedded in the first isolation portion. The second isolation portion is formed from a first surface side, and an insulating reflective member is embedded in the second isolation portion. The first isolation portion penetrates through the second semiconductor region.

## Description

### Technical Field

The present invention relates to a photoelectric conversion device and an image capturing system using the photoelectric conversion device.

### Background Art

In a known photoelectric conversion device, a reflector plate is provided in a wiring layer. This reflector plate reflects incident light having transmitted through a semiconductor substrate so as to increase the optical path length of the incident light in a photoelectric conversion element. Thus, quantum conversion efficiency is improved. PTL 1 describes a single photon avalanche diode (SPAD) including a reflector plate and an inter-pixel isolation portion in which a metal film is embedded.

### Citation List

### Patent Literature

PTL 1: Japanese Patent Laid-Open No. 2018-088488

### Summary of Invention

### Technical Problem

With the structure disclosed in PTL 1, optical crosstalk can be reduced by the metal film embedded in the isolation portion. However, there are concerns about reduction of the sensitivity due to absorption of the incident light.

The present invention has been made in view of the above-described problem and is aimed at both suppression of optical crosstalk and improvement of the sensitivity.

### Solution to Problem

An aspect of the present invention is a photoelectric conversion device that includes a semiconductor layer having a first surface and a second surface facing the first surface. The semiconductor layer includes a plurality of avalanche photodiodes. The plurality of avalanche photodiodes include a first avalanche photodiode and a second avalanche photodiode. The first avalanche photodiode and the second avalanche photodiode each include a first semiconductor region of a first conductivity type and a second semiconductor region of a second conductivity type. The first semiconductor region and the second semiconductor region are arranged in this order from a second surface side. A PN bonding portion is formed between the first semiconductor region and the second semiconductor region. A first isolation portion and a second isolation portion are provided between the first avalanche photodiode and the second avalanche photodiode. The first isolation portion is formed from the second surface side, and a light absorbing material is embedded in the first isolation portion. The second isolation portion is formed from a first surface side, and an insulating reflective member is embedded in the second isolation portion. The first isolation portion penetrates through the second semiconductor region.

### Advantageous Effects of Invention

According to the present invention, both the suppression of optical crosstalk and the improvement of the sensitivity can be achieved.

### Brief Description of Drawings

[Fig. 1] Fig. 1 is a schematic diagram of a photoelectric conversion device according to embodiments.
[Fig. 2] Fig. 2 is a schematic diagram of a sensor substrate of the photoelectric conversion device according to the embodiments.
[Fig. 3] Fig. 3 is a schematic diagram of a circuit substrate of the photoelectric conversion device according to the embodiments.
[Fig. 4] Fig. 4 illustrates an example of a configuration of a pixel circuit of the photoelectric conversion device according to the embodiments.
[Fig. 5] Fig. 5 includes diagrams illustrating drive of the pixel circuit of the photoelectric conversion device according to the embodiments.
[Fig. 6A] Fig. 6A is a sectional view of pixel portions of the photoelectric conversion device according to a first embodiment.
[Fig. 6B] Fig. 6B is a sectional view of the pixel portions of the photoelectric conversion device according to the first embodiment.
[Fig. 7] Fig. 7 is a plan view of the pixel portions of the photoelectric conversion device according to the first embodiment.
[Fig. 8A] Fig. 8A is a sectional view illustrating a method for manufacturing according to the first embodiment.
[Fig. 8B] Fig. 8B is a sectional view illustrating the method for manufacturing according to the first embodiment.
[Fig. 8C] Fig. 8C is a sectional view illustrating the method for manufacturing according to the first embodiment.
[Fig. 9A] Fig. 9A is a sectional view illustrating the method for manufacturing according to the first embodiment.
[Fig. 9B] Fig. 9B is a sectional view illustrating the method for manufacturing according to the first embodiment.
[Fig. 10A] Fig. 10A is a sectional view of a photoelectric conversion device according to a second embodiment.
[Fig. 10B] Fig. 10B is a sectional view of the photoelectric conversion device according to the second embodiment.
[Fig. 11] Fig. 11 is a plan view of the pixel portions of the photoelectric conversion device according to the second embodiment.
[Fig. 12A] Fig. 12A is a sectional view illustrating a method for manufacturing according to the second embodiment.
[Fig. 12B] Fig. 12B is a sectional view illustrating the method for manufacturing according to the second embodiment.
[Fig. 12C] Fig. 12C is a sectional view illustrating the method for manufacturing according to the second embodiment.
[Fig. 12D] Fig. 12D is a sectional view illustrating the method for manufacturing according to the second embodiment.
[Fig. 13A] Fig. 13A is a sectional view illustrating the method for manufacturing according to the second embodiment.
[Fig. 13B] Fig. 13B is a sectional view illustrating the method for manufacturing according to the second embodiment.
[Fig. 14A] Fig. 14A is a sectional view of a photoelectric conversion device according to a third embodiment.
[Fig. 14B] Fig. 14B is a sectional view of the photoelectric conversion device according to the third embodiment.
[Fig. 15] Fig. 15 is a plan view of the photoelectric conversion device according to the third embodiment.
[Fig. 16A] Fig. 16A is a sectional view illustrating a method for manufacturing according to the second embodiment.
[Fig. 16B] Fig. 16B is a sectional view illustrating the method for manufacturing according to the second embodiment.
[Fig. 16C] Fig. 16C is a sectional view illustrating the method for manufacturing according to the second embodiment.
[Fig. 16D] Fig. 16D is a sectional view illustrating the method for manufacturing according to the second embodiment.
[Fig. 17A] Fig. 17A is a sectional view of the pixel portions of a photoelectric conversion device according to a fourth embodiment.
[Fig. 17B] Fig. 17B is a sectional view of the pixel portions of the photoelectric conversion device according to the fourth embodiment.
[Fig. 18A] Fig. 18A is a plan view of the pixel portions of the photoelectric conversion device according to the fourth embodiment.
[Fig. 18B] Fig. 18B is a plan view of the pixel portions of the photoelectric conversion device according to the fourth embodiment.
[Fig. 19A] Fig. 19A is a sectional view of the pixel portions of a modification of the photoelectric conversion device according to the fourth embodiment.
[Fig. 19B] Fig. 19B is a sectional view of the pixel portions of the modification of the photoelectric conversion device according to the fourth embodiment.
[Fig. 20] Fig. 20 is a sectional view of the pixel portions of a photoelectric conversion device according to a fifth embodiment.
[Fig. 21] Fig. 21 is a diagram of a potential of the pixel portions of the photoelectric conversion device according to the fifth embodiment.
[Fig. 22] Fig. 22 is a function block diagram of a photoelectric conversion system according to a sixth embodiment.
[Fig. 23A] Fig. 23A is a function block diagram of a photoelectric conversion system according to a seventh embodiment.
[Fig. 23B] Fig. 23B is a function block diagram of the photoelectric conversion system according to the seventh embodiment.
[Fig. 24] Fig. 24 is a function block diagram of a photoelectric conversion system according to an eighth embodiment.
[Fig. 25] Fig. 25 is a function block diagram of a photoelectric conversion system according to a ninth embodiment.
[Fig. 26A] Fig. 26A is a function block diagram of a photoelectric conversion system according to a tenth embodiment.
[Fig. 26B] Fig. 26B is a function block diagram of the photoelectric conversion system according to the tenth embodiment.

### Description of Embodiments

The following embodiments are intended to embody the technical gist of the present invention but not to limit the present invention. The sizes and the positional relationships of members illustrated in the drawings may be exaggerated for the sake of clarity of the illustration. In the following description, the same elements may be denoted by the same reference numerals, thereby to omit description thereof.

Hereinafter, the embodiments of the present invention are described in detail with reference to the drawings. In the following description, terms indicating specific directions and positions (for example, "above", "below", "right", "left", and other terms including these terms) are used according to need. Use of these terms is intended to increase ease of understanding of the embodiments with reference to the drawings. It is not intended that the meaning of these terms limit the technical scope of the present invention.

Herein, the term "plan view" refers to looking in a direction perpendicular to a light incident surface of a semiconductor layer. The term "sectional view" refers to a plane in a direction perpendicular to the light incident surface of the semiconductor layer. When the microscopically seen light incident surface of the semiconductor layer is a rough surface, the plan view is defined with reference to a macroscopically seen light incident surface of the semiconductor layer.

In the following description, an anode of an avalanche photodiode (APD) is a fixed potential, and a signal is fetched from the cathode side. Accordingly, a semiconductor region of a first conductivity type is an N-type semiconductor region. In the semiconductor region of the first conductivity type, electric charges of the same polarity as the polarity of signal electric charges are a majority carrier. A semiconductor region of a second conductivity type is a P-type semiconductor region. In the semiconductor region of the second conductivity type, electric charges of a different polarity from the polarity of the signal electric charges are a majority carrier. The present invention also holds when the cathode of the APD is the fixed potential, and the signal is fetched from the anode side. In this case, a semiconductor region of the first conductivity type is the P-type semiconductor region. In the semiconductor region of the first conductivity type, the electric charges of the same polarity as the polarity of the signal electric charges are the majority carrier. A semiconductor region of the second conductivity type is the N-type semiconductor region. In the semiconductor region of the second conductivity type, the electric charges of a different polarity from the polarity of the signal electric charges are the majority carrier. In the following description, one of the nodes of the APD is the fixed potential. However, the potentials of both the nodes may vary.

Herein, when the term "impurity concentration" is simply used, this means a net impurity concentration acquired by subtracting an amount compensated by the impurities of an opposite conductivity type. That is, the "impurity concentration" refers to a net doping concentration. A region in which an added impurity concentration of the P type is higher than the added impurity concentration of the N type is a P-type semiconductor region. In contrast, a region in which an added impurity concentration of the N type is higher than the added impurity concentration of the P type is an N-type semiconductor region.

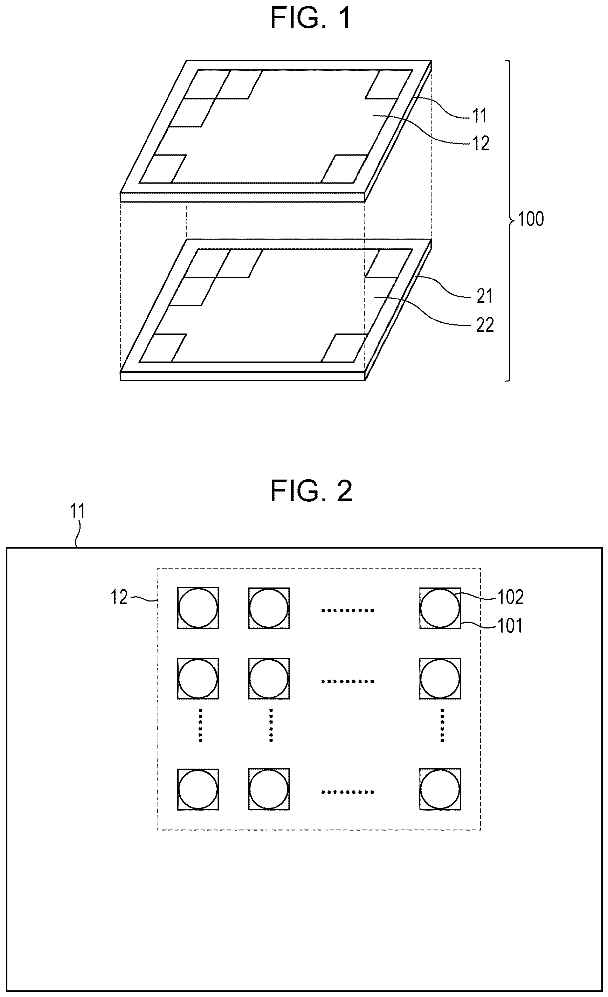

Configurations of the photoelectric conversion device and a method for driving the photoelectric conversion device common to the embodiments will be described with reference to Figs. 1 to 5. The photoelectric conversion device and the method for driving the photoelectric conversion device are usable with a processing device according to the present invention. Although the processing device is provided outside the photoelectric conversion device in the present description, the processing device may be disposed in the photoelectric conversion device.

Fig. 1 illustrates the configuration of a lamination-type photoelectric conversion device 100 according to the embodiments of the present invention.

The photoelectric conversion device 100 is formed by laminating two substrates including a sensor substrate 11 and a circuit substrate 21 together and electrically connecting these substrates to each other. The sensor substrate 11 includes a first wiring structure and a first semiconductor layer including photoelectric conversion elements 102, which will be described later. The circuit substrate 21 includes a second wiring structure and a second semiconductor layer including circuits such as signal processing units 103, which will be described later. The photoelectric conversion device 100 is formed by laminating the second semiconductor layer, the second wiring structure, the first wiring structure, and the first semiconductor layer in this order. The photoelectric conversion device according to the embodiments is of a rear surface irradiation-type in which the light enters through a first surface and the circuit substrate is disposed on a second surface.

Although the sensor substrate 11 and the circuit substrate 21 are diced chips in the description below, the sensor substrate 11 or the circuit substrate 21 is not limited to a chip. For example, each substrate may be a wafer. The substrates in the form of a wafer may be laminated together and then diced. Alternatively, the substrates separated into chips may be laminated and then bonded together.

A pixel region 12 is disposed in the sensor substrate 11. A circuit region 22 configured to process signals detected in the pixel region 12 is disposed in the circuit substrate 21.

Fig. 2 illustrates an example of arrangement in the sensor substrate 11. Pixels 101 including the photoelectric conversion elements 102 including the APDs are arranged in a two-dimensional array shape in plan view. Thus, the pixel region 12 is formed.

Although the pixels 101 are typically used for forming images, the pixels 101 do not necessarily form images when used in Time of Flight (TOF). That is, the pixels 101 may be pixels that measure the amount of light and time at which the light arrives.

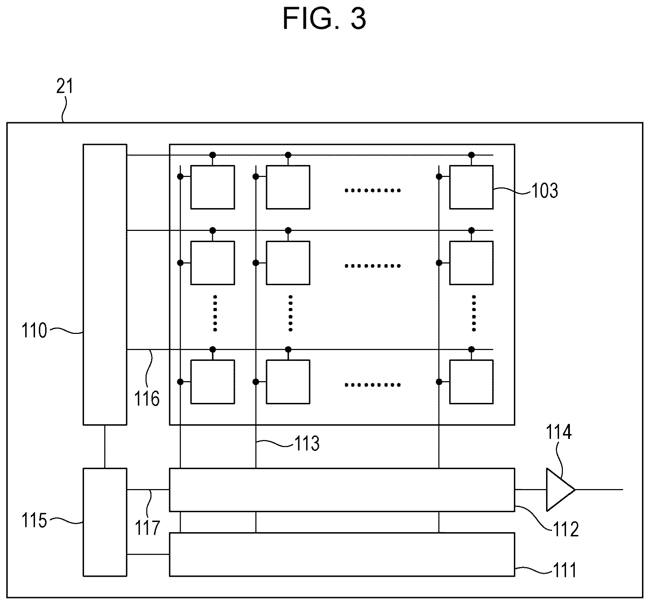

Fig. 3 illustrates the configuration of the circuit substrate 21. The circuit substrate 21 includes the signal processing units 103 configured to process the electric charges having undergone photoelectric conversion by the photoelectric conversion elements 102 illustrated in Fig. 2, a column circuit 112, a control pulse generation unit 115, a horizontal scanning circuit unit 111, signal lines 113, and a vertical scanning circuit unit 110.

The photoelectric conversion elements 102 illustrated in Fig. 2 and the signal processing units 103 illustrated in Fig. 3 are electrically connected to each other via connection wiring provided on a pixel-by-pixel bases.

The vertical scanning circuit unit 110 receives control pulses supplied from the control pulse generation unit 115 and supplies the control pulses to the pixels. A logic circuit such as a shift register or an address decoder is used for the vertical scanning circuit unit 110.

The signals output from the photoelectric conversion elements 102 of the pixels are to be processed by the signal processing units 103. A counter, memory, and the like are provided in the signal processing units 103, and the memory holds digital values.

The horizontal scanning circuit unit 111 inputs to the signal processing units 103 control pulses that select columns one after another so as to read the signals from memory of pixels in which digital signals are held.

For the selected column, the signals are output from the signal processing units 103 of the pixels selected by the vertical scanning circuit unit 110 to the signal lines 113.

The signals output to the signal lines 113 are output to a recording unit or a signal processing unit outside the photoelectric conversion device 100 via an output circuit 114.

Referring to Fig. 2, the photoelectric conversion elements may be arranged in a one-dimensional manner in the pixel region. A single function of the signal processing units is not necessarily provided in each of all the photoelectric conversion elements. For example, a single signal processing unit may be shared between a plurality of photoelectric conversion elements and perform signal processing sequentially.

As illustrated in Figs. 2 and 3, a plurality of signal processing units 103 are disposed in a region superposed on the pixel region 12 in plan view. In plan view, the vertical scanning circuit unit 110, the horizontal scanning circuit unit 111, the column circuit 112, the output circuit 114, and the control pulse generation unit 115 are disposed so as to be superposed on a space between ends of the sensor substrate 11 and ends of the pixel region 12. In other words, the sensor substrate 11 has the pixel region 12 and a non-pixel region disposed around the pixel region 12. In plan view, the vertical scanning circuit unit 110, the horizontal scanning circuit unit 111, the column circuit 112, the output circuit 114, and the control pulse generation unit 115 are disposed in a region superposed on the non-pixel region.

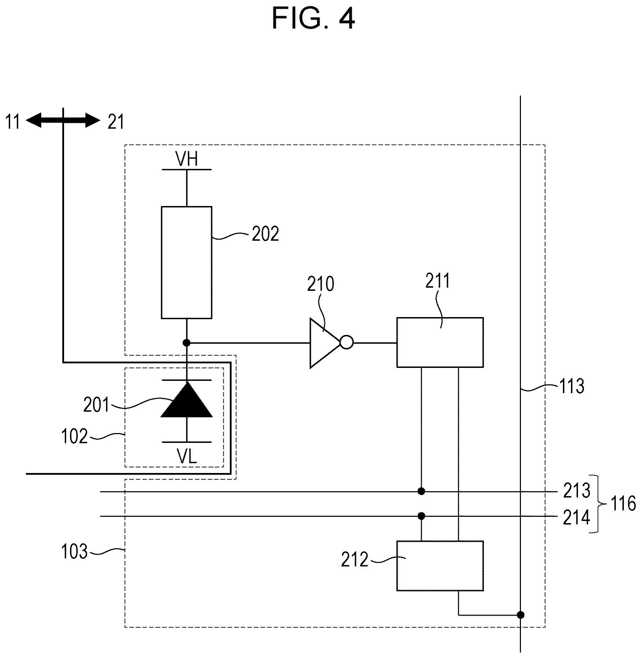

Fig. 4 is an example of a block diagram including equivalent circuits of Figs. 2 and 3.

Referring to Fig. 2, each of the photoelectric conversion elements 102 including an APD 201 is provided on the sensor substrate 11 and other members are provided on the circuit substrate 21.

The APD 201 is a photoelectric conversion unit configured to generate electric charge pairs corresponding to the incident light by using photoelectric conversion.

A voltage VL (first voltage) is supplied to the anode of the APD 201. Furthermore, a voltage VH (second voltage), which is higher than the voltage VL supplied to the anode, is supplied to the cathode of the APD 201. Such reverse bias voltages with which the APD 201 performs an avalanche multiplication operation are supplied to the anode and the cathode. When such voltages are supplied, electric charges generated by the incident light cause avalanche multiplication, and an avalanche current is generated.

When reverse bias voltages are supplied, there are a Geiger mode and a linear mode. In the Geiger mode, operation is performed by applying a potential difference greater than a breakdown voltage to the anode and cathode. In the linear mode, operation is performed by setting a potential difference between the anode and cathode to be close to the breakdown voltage or smaller than or equal to the breakdown voltage. The APD 201 may be operated in the linear mode or the Geiger mode.

An APD operated in the Geiger mode is referred to as a single-photon avalanche diode (SPAD). In the case of the SPAD, the potential difference increases compared to the APD of the linear mode, and an effect of improvement of the signal-to-noise ratio is significant. Accordingly, the APD 201 is preferably a SPAD. At this time, for example, the voltage VL (first voltage) is -30 V, and the voltage VH (second voltage) is 1 V.

A quench element 202 is connected between a power source that supplies the voltage VH and the APD 201. The quench element 202 is configured to function as a load circuit (quench circuit) in signal multiplication due to the avalanche multiplication so as to suppress the voltage supplied to the APD 201, thereby suppressing the avalanche multiplication (quench operation). Also, the quench element 202 flows a current corresponding to the voltage drop due to the quench operation so as to return the voltage to be supplied to the APD 201 to the voltage VH (recharge operation).

Each signal processing unit 103 includes a waveform shaping unit 210 and a counter circuit 211. Herein, it is sufficient that the signal processing unit 103 include one of the waveform shaping unit 210 and the counter circuit 211.

The waveform shaping unit 210 is configured to shape changes in potential of the cathode of the APD 201 acquired in detection of a photon and output pulse signals. As the waveform shaping unit 210, for example, an inverter circuit is used. A circuit in which a plurality of inverters are connected in series may be used, or another circuit producing the waveform shaping effect may be used.

The counter circuit 211 is configured to count the pulse signals output from the waveform shaping unit 210 and holds count values.

A switch such as a transistor may be disposed between the quench element 202 and the APD 201 or between the photoelectric conversion element 102 and the signal processing unit 103 so as to switch electrical connection. Likewise, supply of the voltage VH or VL to be supplied to the photoelectric conversion element 102 may be electrically switched by using a switch such as a transistor.

The configuration described according to the present embodiments uses the counter circuit 211. However, the photoelectric conversion device 100 may acquire pulse detection timing by using a time to digital converter (TDC) and memory instead of the counter circuit 211. At this time, generation timing of the pulse signal output from the waveform shaping unit 210 is converted into a digital signal by using the TDC. A control pulse pREF (reference signal) is supplied from the vertical scanning circuit unit 110 illustrated in Fig. 1 to the TDC via a drive line to measure the timing of the pulse signal. Via the waveform shaping unit 210, the TDC acquires, as a digital signal, a signal acquired when input timing of a signal output from each pixel is set as relative time with reference to the control pulse pREF.

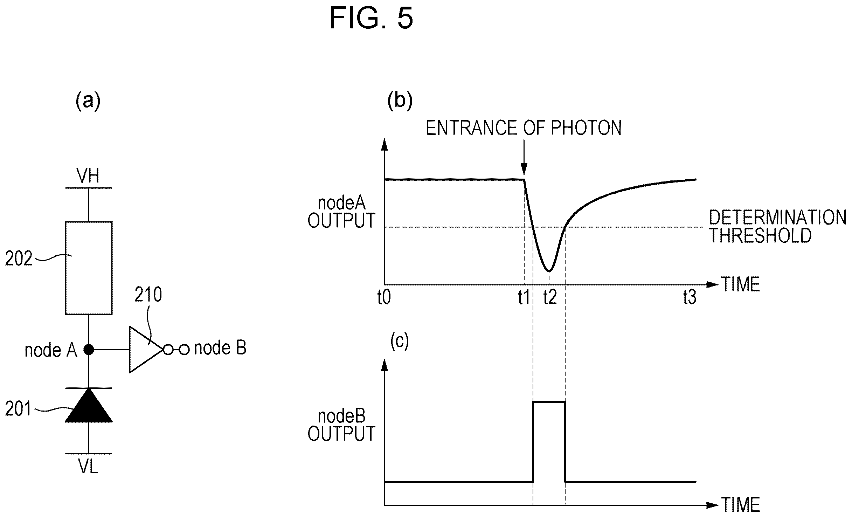

Fig. 5 includes diagrams schematically illustrating the relationship between the operation of the APD and an output signal.

In Fig. 5 (a), the APD 201, the quench element 202, and the waveform shaping unit 210 illustrated in Fig. 4 are extracted. Here, the input side of the waveform shaping unit 210 is defined as a node A, and the output side of the waveform shaping unit 210 is defined as a node B. Fig. 5 (b) illustrates waveform changes of the node A illustrated in Fig. 5 (a). Fig. 5 (c) illustrates waveform changes of the node B illustrated in Fig. 5 (a).

Between time t0 and time t1, a potential difference of VH - VL is applied to the APD 201 illustrated in Fig. 5 (a). At the time t1, when the photon enters the APD 201, the avalanche multiplication occurs in the APD 201, an avalanche multiplication current flows in the quench element 202, and the voltage of the node A drops. When the amount of the voltage drop further increases and the potential difference applied to the APD 201 reduces, the avalanche multiplication of the APD 201 stops as observed at time t2, and a voltage level of node A does not drop further from a certain value. After that, between the time t2 and time t3, a current compensating for the voltage drop from the voltage VL flows in the node A, and, at the time t3, the node A is statically determinate at the original potential level. At this time, part of an output waveform exceeding a certain threshold at the node A is subjected to the waveform shaping performed by the waveform shaping unit 210 and output as the signal at the node B.

None of arrangement of the signal lines 113, the column circuit 112, and arrangement of the output circuit 114 are not limited to those illustrated in Fig. 3. For example, the signal lines 113 may extend in a line direction, and the column circuit 112 may be disposed in a region toward which the signal lines 113 extend.

Hereinafter, the photoelectric conversion device according to the embodiments will be described.

### (First Embodiment)

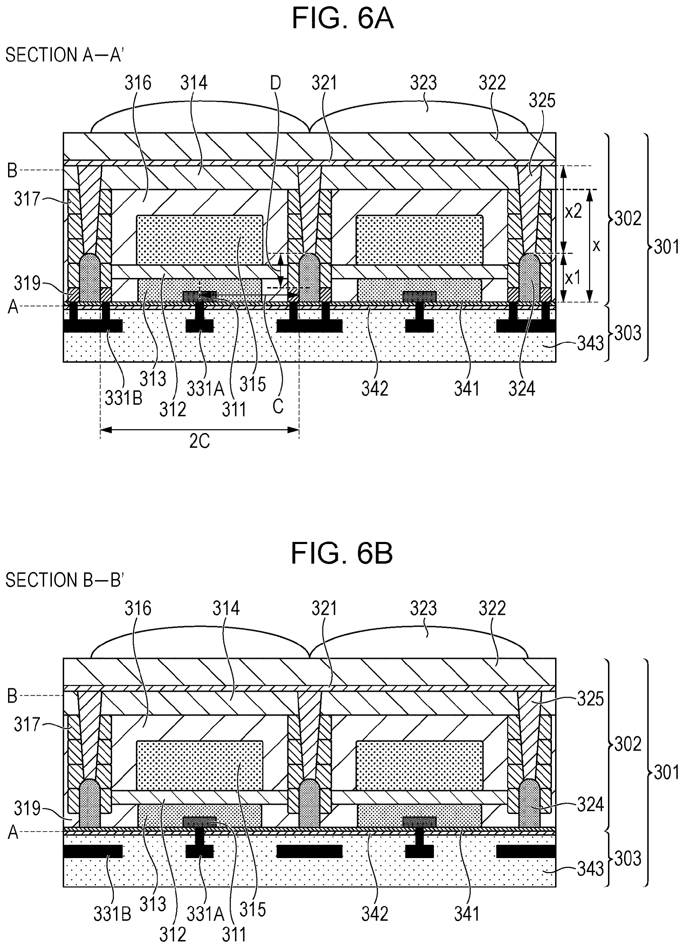

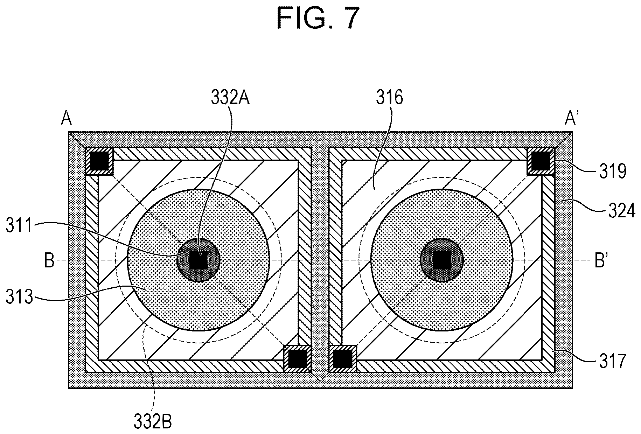

The photoelectric conversion device according to a first embodiment is described with reference to Figs. 6A and 6B and Fig. 7.

Fig. 6A is a sectional view of two pixels of the photoelectric conversion elements 102 of the photoelectric conversion device according to the first embodiment in a direction perpendicular to a planar direction of the substrate. Fig. 6A corresponds to section A-A' illustrated in Fig. 7. Fig. 6B corresponds to section B-B' illustrated in Fig. 7.

Fig. 7 is a pixel plan view of two pixels of the photoelectric conversion device according to the first embodiment in plan view seen from a surface facing the light incident surface.

The structure and function of the photoelectric conversion element 102 are described with reference to Figs. 6A and 6B. The photoelectric conversion element 102 includes N-type semiconductor regions including a first semiconductor region 311, a third semiconductor region 313, a fifth semiconductor region 315, and a sixth semiconductor region 316. The photoelectric conversion element 102 also includes P-type semiconductor regions including a second semiconductor region 312, a fourth semiconductor region 314, a seventh semiconductor region 317, and a ninth semiconductor region 319.

According to the preset embodiment, in the section illustrated in Figs. 6A and 6B, the first semiconductor region 311 of the N-type is formed near the surface facing the light incident surface, and the third semiconductor region 313 of the N-type is formed around the first semiconductor region 311. The second semiconductor region 312 of the P-type is formed at a position superposed on the first semiconductor region and the second semiconductor region in plan view. Furthermore, the fifth semiconductor region 315 of the N-type is disposed at a position superposed on the second semiconductor region 312 in plan view, and the sixth semiconductor region 316 of the N-type is formed around the fifth semiconductor region 315.

The impurity concentration of the N type is higher in the first semiconductor region 311 than in the third semiconductor region 313 and fifth semiconductor region 315. A PN bonding portion is formed between the P-type second semiconductor region 312 and the N-type first semiconductor region 311. When the impurity concentration is lower in the second semiconductor region 312 than in the first semiconductor region 311, the entirety of a region of the second semiconductor region 312 superposed on the center of the first semiconductor region in plan view becomes a depletion layer region. At this time, the potential difference is greater between the first semiconductor region 311 and the second semiconductor region 312 than between the second semiconductor region 312 and the fifth semiconductor region 315. Furthermore, this depletion layer region extends toward a partial region of the first semiconductor region 311, and an intense electric field is induced in the depletion layer region having extended. Due to this intense electric field, the avalanche multiplication occurs in the depletion layer region having extended in the partial region of the first semiconductor region 311, and a current based on amplified electric charges is output as signal electric charges. When the light incident upon the photoelectric conversion element 102 undergoes photoelectric conversion and the avalanche multiplication occurs in the depletion layer region (avalanche multiplication region), the generated electric charges of the first conductivity type are collected by the first semiconductor region 311.

Referring to Figs. 6A and 6B, the third semiconductor region 313 and the fifth semiconductor region 315 have about the same size in the planar direction. However, this does not limit the size of each semiconductor region. For example, the fifth semiconductor region 315 may have a larger size than the size of the third semiconductor region 313 so as to collect the electric charges from a larger range to the first semiconductor region 311.

The third semiconductor region 313 may be a semiconductor region of the P-type instead of the N-type.

In this case, the impurity concentration is set to be lower in the third semiconductor region 313 than in the second semiconductor region 312. When the impurity concentration is excessively high in the third semiconductor region 313, an avalanche multiplication region is made between the third semiconductor region 313 and the first semiconductor region 311, and a dark count rate (DCR) increases.

Fig. 7 illustrates the positional relationship between a cathode wiring 331Aand an anode wiring 331B illustrated in Figs. 6A and 6B. A cathode wiring end 332A is contained in the first semiconductor region 311 in the horizontal direction, and an anode wiring end 332B is disposed at a position not superposed on the third semiconductor region 313 in the horizontal direction.

As illustrated in Figs. 6A and 6B, pixels are electrically isolated from each other by a first isolation portion 324 and a second isolation portion 325 that have a trench structure. The first isolation portion 324 is formed from the surface facing the light incident surface of the semiconductor layer, and the second isolation portion 325 is formed from the light incident surface side of the semiconductor layer.

The second isolation portion 325 is in contact with the first isolation portion 324 in the vertical direction. At this time, the position of a bottom portion of the first isolation portion 324 and the position of a bottom portion of the second isolation portion 325 are not necessarily coincident with each other. The first isolation portion 324 and the second isolation portion 325 may be in contact with each other at a trench side wall. Contact of the first isolation portion 324 and the second isolation portion 325 with each other can produce an effect of reducing light emission crosstalk generated by transmission of light emission in the avalanche multiplication region to the adjacent pixel.

Here, a depth x1 of the first isolation portion 324, a depth x2 of the second isolation portion 325, and a thickness X of the sixth semiconductor region 316 satisfy the following relationships: x1 + x2 > X. At least one of the first isolation portion 324 and the second isolation portion 325 may have a forward tapered shape.

As illustrated in Fig. 7, first isolation portions 324 form a lattice shape in plan view.

A conductive material (such as tungsten, titanium, aluminum, gold, silver, copper, or platinum) and a member containing a metallic compound (such as titanium nitride, tantalum nitride, or molybdenum oxide) are embedded in the first isolation portion 324. For preventing the current from flowing from the second semiconductor region 312 to the first semiconductor region 311 via the first isolation portion 324, it is necessary that an insulating material such as an oxide film be embedded in the first isolation portion 324 before the conductive material is embedded in the first isolation portion 324. When the structure in which the insulating film is embedded before the conductive material is embedded is used as described above, the following effects are produced: metallic diffusion from the conductive material to a first semiconductor layer 302 is prevented; and the DCR is suppressed.

The bottom portion of the first isolation portion 324 is formed to a position deeper than the second semiconductor region 312 in the vertical direction. In the avalanche multiplication region between the first semiconductor region 311 and the second semiconductor region 312, avalanche light emission may occur. In the avalanche light emission, photons are generated when many electrons or holes generated by the avalanche multiplication are recombined with electric charges having a different polarity. When the photons generated by the avalanche light emission leak to the adjacent pixel, false signals are generated. This leads to degradation of image quality. When the first isolation portion 324 is formed so as to be deeper than the second semiconductor region 312, the light that has been generated by the avalanche light emission and is traveling toward the adjacent pixel can be blocked by the first isolation portion 324, and accordingly, the light emission crosstalk can be reduced. The position of the bottom portion of the first isolation portion 324 in the vertical direction is between the second semiconductor region 312 and the fifth semiconductor region 315.

Meanwhile, an insulating reflective member is embedded in the second isolation portion 325. Accordingly, the light incident upon the isolation portion 325 can be reflected and subjected to the avalanche multiplication in the first semiconductor layer 302. The reflective member of the second isolation portion 325 may be formed of an oxide film, a nitride film, a fixed electric charge film (such as Al₂O₃ or HfO₂) or a combination of a plurality of these films. At this time, as the extinction coefficient reduces, the attenuation of the incident light can be reduced more. Thus, a member having a small extinction coefficient is preferred.

When the first isolation portion 324 and the second isolation portion 325 are filled with a member satisfying a predetermined refractive index, an effect of improving the sensitivity can be more strongly acquired while the light emission crosstalk is suppressed.

When a distance C is from the center of the first semiconductor region 311 included in the avalanche multiplication region of the photoelectric conversion element 102 to the side wall of the first isolation portion 324, a distance D is from the avalanche multiplication region to a point where the first isolation portion 324 and the second isolation portion 325 are in contact with each other in the vertical direction, a refractive index n1 is of silicon included in the sixth semiconductor region 316, and a refractive index n2 is of a member with which the second isolation portion 325 is filled, preferably, D ≥ C × tan{asin(n2/n1)} is satisfied. The reason for this is that, when the above-described relational expression is satisfied, the light of the avalanche light emission generated in the avalanche multiplication region is, in the calculation, totally reflected by the first isolation portion 324 and the second isolation portion 325.

When the first isolation portion 324 and the second isolation portion 325 having these features are combined, the effect of improving the sensitivity can be acquired while the light emission crosstalk to the adjacent pixel is suppressed. A fixed electric charge film 321 formed of Al₂O₃ or HfO₂, a planarizing layer 322, and a microlens 323 are further formed on the light incident surface side of the first semiconductor layer 302.

When two pixels illustrated in Figs. 6A and 6B are defined as a first avalanche photodiode and a second avalanche photodiode, the first isolation portion 324 and the second isolation portion 325 are provided between the first avalanche photodiode and the second avalanche photodiode.

When a third avalanche photodiode is further provided adjacent to the second avalanche photodiode, the second avalanche photodiode and the third avalanche photodiode are isolated from each other by a third isolation portion and a fourth isolation portion. The configurations of the third isolation portion and the fourth isolation portion are respectively similar to those of the first isolation portion and the second isolation portion.

At this time, when a distance 2C is from a side wall of the second isolation portion in a third surface on a first surface side of the first semiconductor region 311 of the second avalanche photodiode to a side wall of the fourth isolation portion, a distance D is from the third surface to a point where the first isolation portion and the second isolation portion are in contact with each other in the vertical direction, the refractive index n1 is of silicon included in the sixth semiconductor region 316, and the refractive index n2 is of a member with which the second isolation portion 325 and the fourth isolation portion are filled, it can be said that, preferably, D ≥ C × tan{asin(n2/n1)} is satisfied.

A wiring structure including a conductor and an insulating film is provided on the surface facing the light incident surface of the semiconductor layer. The photoelectric conversion element 102 illustrated in Figs. 6A and 6B includes an oxide film 341 and a protective film 342 sequentially from a side close to the semiconductor layer, and a wiring layer including a conductor is further laminated. Interlayer films 343 being insulating films are provided between the wiring and the semiconductor layer and between the wiring layers. The protective film 342 is configured to protect the semiconductor layer from plasma damage and metallic contamination during etching. Although SIN being a nitride film is generally used, SiON, SiC, or SiCN may be used.

The photoelectric conversion element 102 illustrated in Figs. 6A and 6B includes the cathode wiring 331A and the anode wiring 331B. The cathode wiring 331A is connected to the first semiconductor region 311. The anode wiring 331B allows supply of the voltage to the seventh semiconductor region 317 via the ninth semiconductor region 319 being an anode contact. The ninth semiconductor region 319 is provided in section A-A' (a diagonal direction of the pixel) illustrated in Fig. 6A. The ninth semiconductor region 319 is not provided in section B-B' (an opposite side direction of the pixel) illustrated in Fig. 6B.

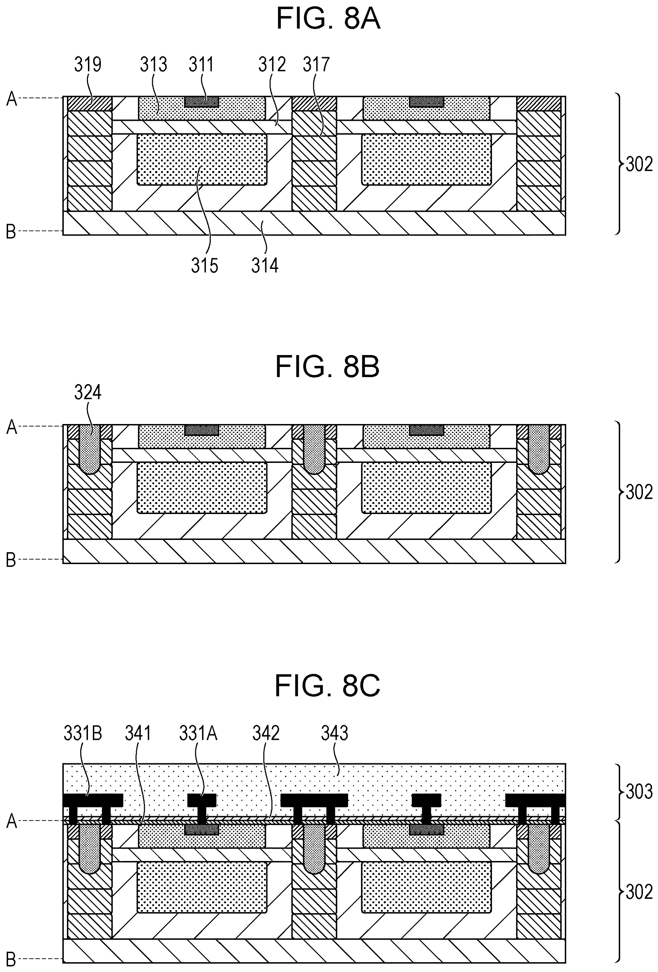

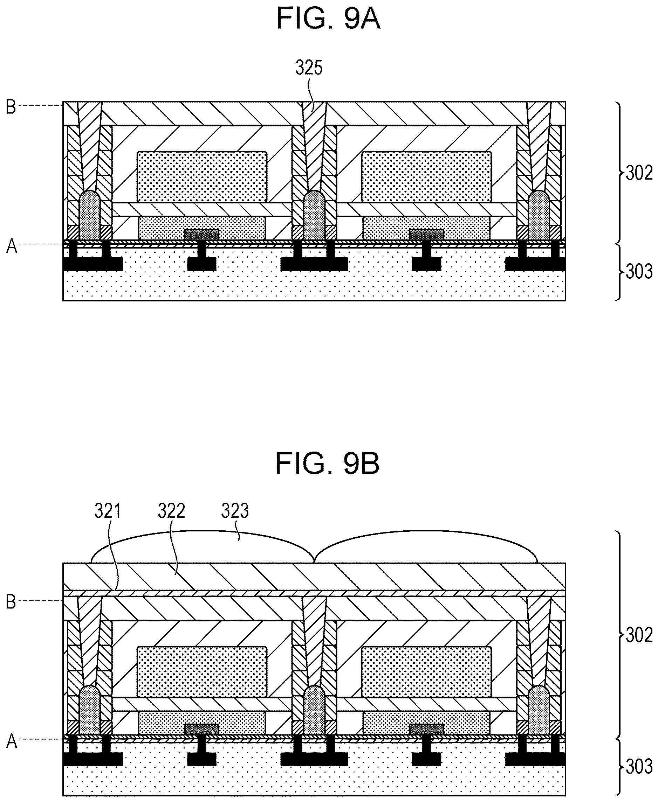

A method for manufacturing the photoelectric conversion device according to the preset embodiment is described with reference to Figs. 8A to 9C. Figs. 8A to 8C illustrate steps in which a substrate including the first semiconductor layer 302 is used as a support substrate. Figs. 9A and 9B illustrate manufacturing steps after substrates have been laminated together.

As illustrated in Fig. 8A, the first to ninth semiconductor regions are formed in the first semiconductor layer 302 by repeatedly performing processes such as photolithography, ion implantation, and thermomigration.

Next, as illustrated in Fig. 8B, the first isolation portion 324 is formed in the first semiconductor layer 302 by etching. For suppressing the DCR due to etching damage, sacrificing oxidation and chemical dry etching are performed, and damage to the surface of the first isolation portion 324 is removed. Due to the above-described removal of the damage, the bottom portion of the first isolation portion 324 has a rounded arc shape so as to reduce stress. This can also reduce the DCR.

At this time, the first isolation portion 324 has a greater thickness than that of the second isolation portion 325. The reason for this is to increase the contact area between the first isolation portion 324 and the second isolation portion 325 when the second isolation portion 325 is formed so as to suppress poor contact caused by variations between the steps, thereby to reliably reduce the crosstalk. After that, the conductive material is embedded in the first isolation portion 324 by, for example, chemical-vapor deposition (CVD) or a sol-gel method.

As illustrated in Fig. 8C, processes such as deposition, photolithography, and etching are repeatedly performed, and a wiring layer 303 is formed from a contact plug to a bonding metal (not illustrated).

Fig. 9A illustrates a state in which a first substrate is bonded to another support substrate or circuit substrate, and the thickness of the substrate is reduced. The second isolation portion 325 is formed by etching from the light incident surface, and the reflective member is embedded by, for example, the CVD or the sol-gel method. The reflective member is an oxide film, a nitride film, a fixed electric charge film, or a combination of a plurality of these films.

As illustrated in Fig. 9B, the fixed electric charge film 321, the planarizing layer 322, and the microlens 323 are formed by a method for processing similar to that for the wiring layer 303.

### (Second Embodiment)

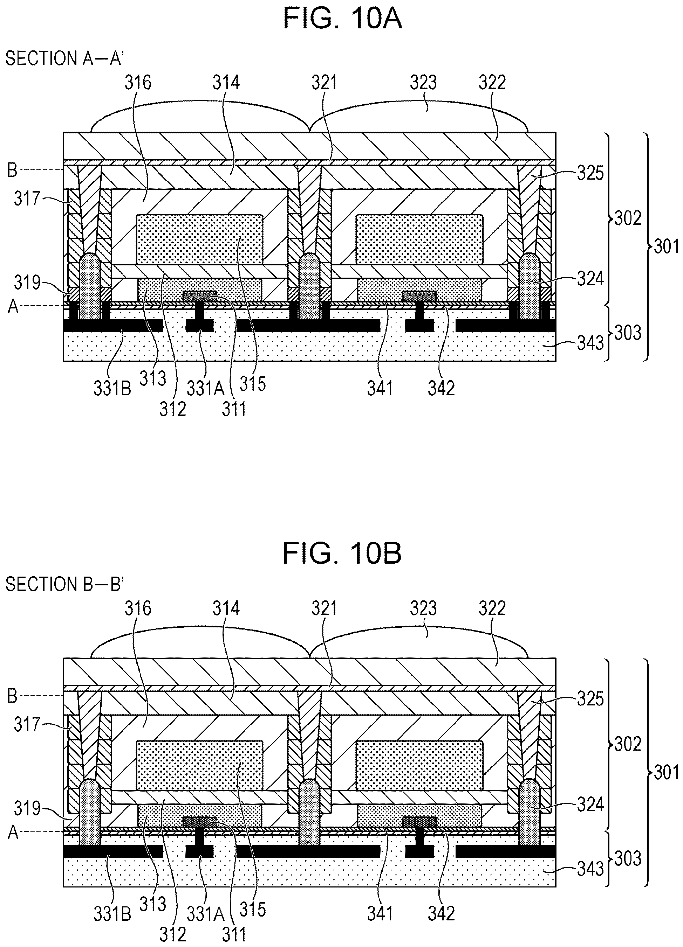

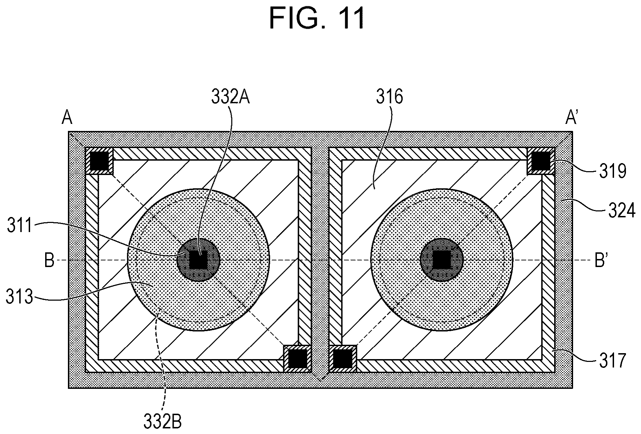

A photoelectric conversion device according to a second embodiment is described with reference to Figs. 10A, 10B, and 11. The common description for the first embodiment and the second embodiment is omitted, and items different from those of the first embodiment are mainly described.

Fig. 10A is a sectional view of two pixels of the photoelectric conversion elements 102 of the photoelectric conversion device according to the second embodiment in the direction perpendicular to the planar direction of the substrate. Fig. 10A corresponds to section A-A' illustrated in Fig. 11. Fig. 10B corresponds to section B-B' illustrated in Fig. 11.

Fig. 11 is a pixel plan view of two pixels of the photoelectric conversion device according to the second embodiment in plan view seen from the surface facing the light incident surface. Fig. 11 illustrates the positional relationship between the cathode wiring 331A and the anode wiring 331B illustrated in Figs. 10A and 10B. The cathode wiring end 332A is contained in the first semiconductor region 311 in the horizontal direction. Furthermore, the anode wiring 331B extends so that the anode wiring end 332B is superposed on the third semiconductor region 313 in the horizontal direction.

Light having entered the first semiconductor layer 302 and then transmitted to the wiring layer 303 without undergoing the avalanche multiplication is reflected by the cathode wiring 331A and the anode wiring 331B. The light having reentered the first semiconductor layer 302 due to the reflection can undergo the avalanche multiplication.

According to the present embodiment, the anode wiring 331B extends toward the cathode wiring 331A for facilitating the occurrences of the above-described reflection and improving the sensitivity. At this time, with the structure of the first isolation portion 324 described in the first embodiment, the light reflected by the anode wiring 331B may pass through the interlayer film between the first isolation portion 324 and the anode wiring 331B and enter the adjacent pixel. Thus, there is the possibility of inducing the light emission crosstalk. According to the present embodiment, as illustrated in Figs. 10A and 10B, the first isolation portion 324 is formed so as to be in contact with the anode wiring 331B. Thus, the light reflected at the anode wiring 331B and entering the adjacent pixel can be blocked. Accordingly, the effect of further improving the sensitivity can be acquired while the light emission crosstalk remains suppressed.

A high voltage is applied to the anode wiring 331B for causing the avalanche multiplication. Thus, when the first isolation portion 324 and the anode wiring 331B are in contact with each other, the voltage can be applied to the conductive material embedded in the first isolation portion 324. This allows formation of a hole accumulation layer on the side wall of the first isolation portion 324 and acquisition of an effect of suppressing the DCR due to, for example, etching damage during the formation of the first isolation portion 324.

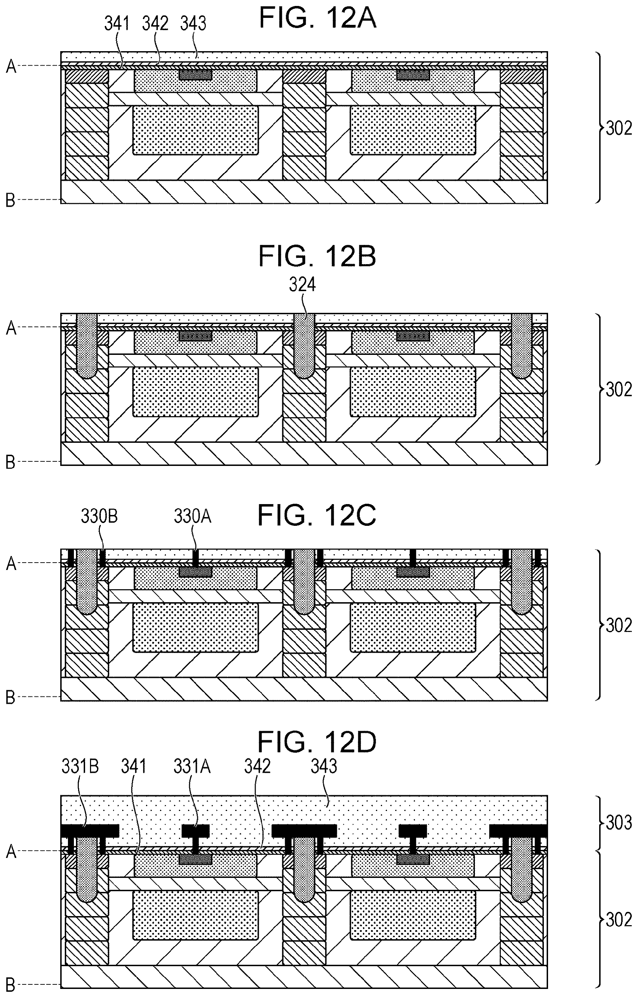

A method for manufacturing the photoelectric conversion device according to the second embodiment is described with reference to Figs. 12A to 13B.

As illustrated in Fig. 12A, the oxide film 341, the protective film 342, and the inter-wiring layer film 343 are deposited in the first semiconductor layer 302 formed in the semiconductor region by, for example, the CVD or the sol-gel method.

Next, as illustrated in Fig. 12B, the first isolation portion 324 is formed in the first semiconductor layer 302 by etching. At this time, the oxide film 341, the protective film 342, the inter-wiring layer film 343, and the sixth semiconductor layer are collectively opened, and the conductive material is embedded by, for example, the CVD or the sol-gel method. The conductive material remaining on the inter-wiring layer film 343 is removed by etching or chemical mechanical polishing (CMP).

As illustrated in Fig. 12C, a cathode contact 330A is formed on the first semiconductor region 311, and an anode contact 330B is formed on the ninth semiconductor region 319. For the formation of each contact, photolithography or etching is used. Furthermore, a first conductive material is embedded in the first isolation portion 324 by, for example, the CVD or the sol-gel method.

As illustrated in Fig. 12D, processes such as deposition, photolithography, and etching are repeatedly performed, and the wiring layer 303 is formed to the bonding metal (not illustrated).

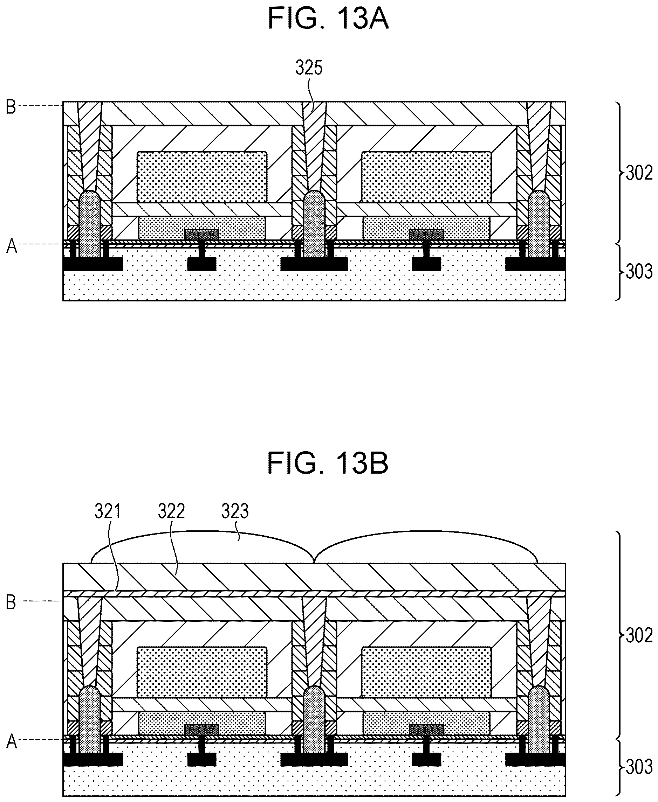

Fig. 13A illustrates a state in which the first substrate is bonded to another support substrate or circuit substrate, and the thickness of the substrate is reduced. The second isolation portion 325 is formed by etching from the light incident surface, and the reflective member is embedded by, for example, the CVD or the sol-gel method. The reflective member is the oxide film, the nitride film, the fixed electric charge film, or the combination of a plurality of these films.

Next, as illustrated in Fig. 13B, the fixed electric charge film 321, the planarizing layer 322, and the microlens 323 are formed by the method for processing similar to that for the wiring layer 303.

### (Third Embodiment)

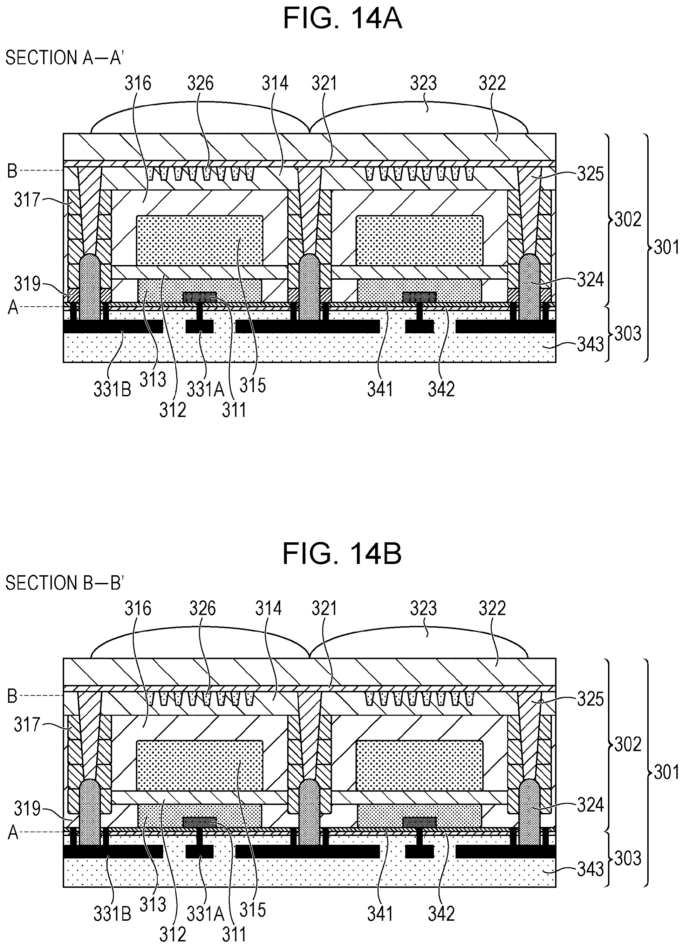

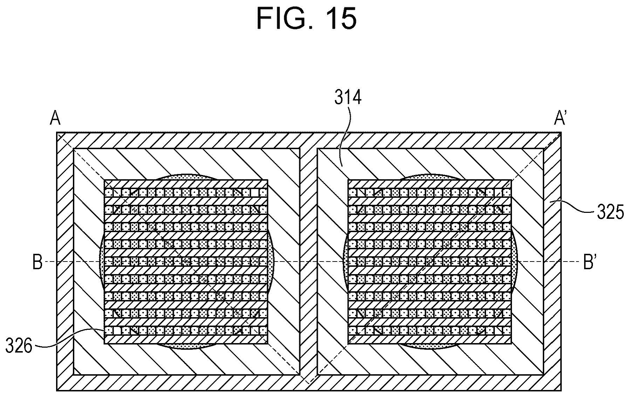

A photoelectric conversion device according to a third embodiment is described with reference to Figs. 14A, 14B, and 15. The structure in plan view from the surface facing the light incident surface is the same as that of the second embodiment illustrated in Fig. 11. The common description for the first embodiment, the second embodiment, and the third embodiment is omitted, and items different from those of the second embodiment are mainly described.

Fig. 14A is a sectional view of two pixels of the photoelectric conversion elements 102 of the photoelectric conversion device according to the third embodiment in the direction perpendicular to the planar direction of the substrate. Fig. 14A corresponds to section A-A' illustrated in Fig. 11. Fig. 14B corresponds to section B-B' illustrated in Fig. 11.

As illustrated in Figs. 14A and 14B, the light incident surface has an uneven structure 326 according to the present embodiment. With the uneven structure 326, the incident light is scattered. Thus, the light entering the first isolation portion 324 and the second isolation portion 325 of the second embodiment increases. When the uneven structure 326 and the first isolation portion 324 and the second isolation portion 325 of the second embodiment are combined, the effect of improving the sensitivity is acquired without degrading the light emission crosstalk.

Fig. 15 is a plan view of the first semiconductor layer 302 in plan view seen from the surface facing the light incident surface. As illustrated in Fig. 15, the uneven structure 326 has a lattice shape in plan view. The uneven structure 326 is formed so as to be superposed on the first semiconductor region 311 and the fifth semiconductor region 315, and the center of gravity of the uneven structure is contained in the avalanche multiplication region in plan view.

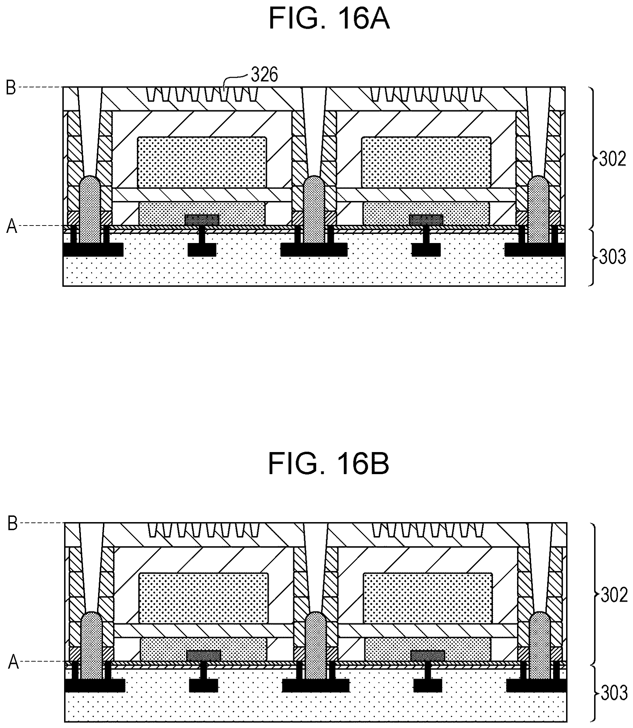

A method for manufacturing the photoelectric conversion device according to the third embodiment is described with reference to Figs. 16A to 16D. The description of Figs. 12A to 13A, which is common for the method for manufacturing according to the second embodiment and the third embodiment, is omitted.

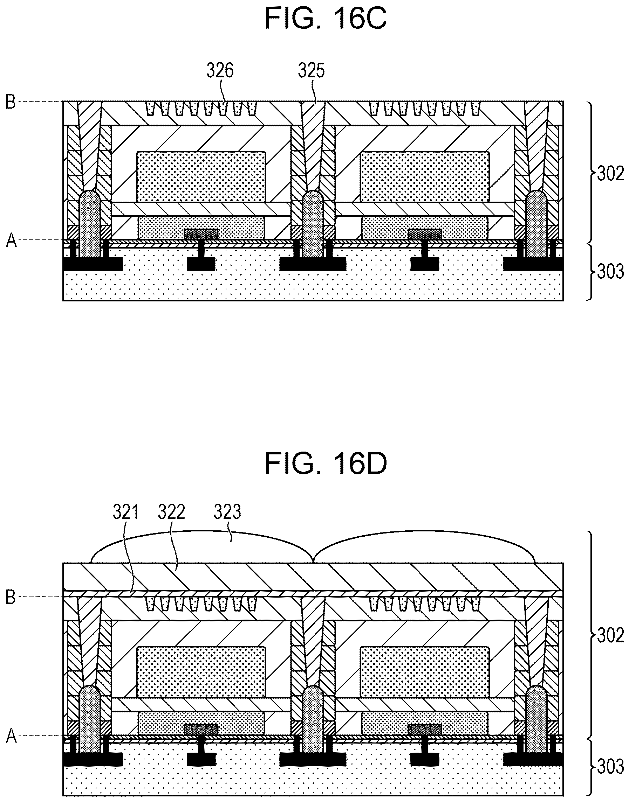

Fig. 16A illustrates a state in which the first substrate is bonded to another support substrate or circuit substrate, and the thickness of the substrate is reduced. As illustrated in Figs. 16A, the uneven structure 326 is formed by etching from the light incident surface. Next, as illustrated in Fig. 16B, the second isolation portion 325 is formed by etching. Next, as illustrated in Fig. 16C, the reflective member is simultaneously embedded in the uneven structure 326 and the second isolation portion 325 by, for example, the CVD or the sol-gel method. The reflective member is the oxide film, the nitride film, the fixed electric charge film, or the combination of a plurality of these films.

As illustrated in Fig. 16D, when processes such as deposition, photolithography, and etching are repeatedly performed, the fixed electric charge film 321, the planarizing layer 322, and the microlens 323 are formed.

### (Fourth Embodiment)

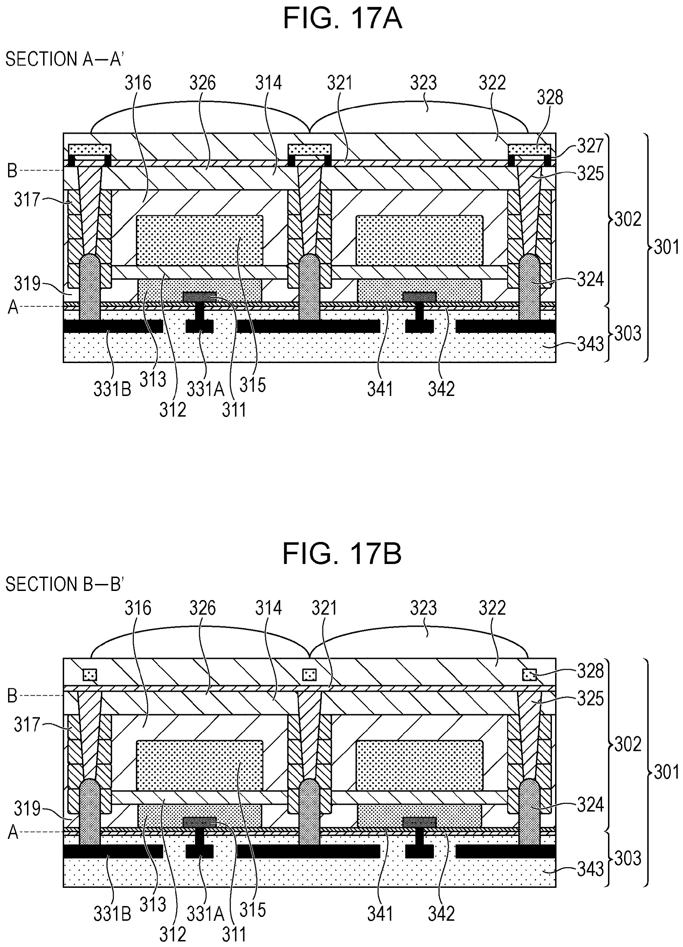

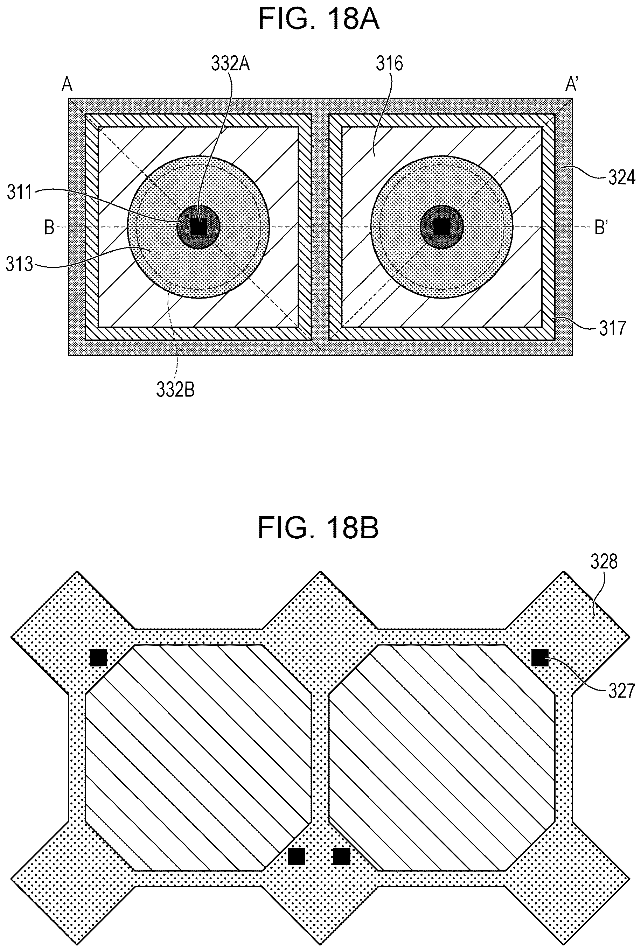

A photoelectric conversion device according to a fourth embodiment is described with reference to Figs. 17A, 17B, 18A, and 18B. The common description for the first embodiment, the second embodiment, the third embodiment, and the fourth embodiment is omitted, and items different from those of the second embodiment are mainly described.

Fig. 17A is a sectional view of two pixels of the photoelectric conversion elements 102 of the photoelectric conversion device according to the third embodiment in the direction perpendicular to the planar direction of the substrate. Fig. 17A corresponds to section A-A' illustrated in Fig. 18A. Fig. 17B corresponds to section B-B' illustrated in Fig. 18A.

Fig. 18A is a pixel plan view of two pixels of the photoelectric conversion device according to the fourth embodiment in plan view seen from the surface facing the light incident surface. Compared to the plan view illustrated in Fig. 11, neither the ninth semiconductor region 319 nor the contact connected to the ninth semiconductor region 319 is formed.

Fig. 18B is a pixel plan view of two pixels of the photoelectric conversion device also according to the fourth embodiment, illustrating a rear surface wiring 328 and an anode contact 327 provided on the light incident surface side.

The difference between the present embodiment and the second embodiment is that the anode contact is provided on the light incident surface side, and the potential is supplied from the light incident surface side to the pixel. Furthermore, the rear surface wiring 328 is disposed on the light incident surface side and connected to a rear surface anode contact. With such a structure, a finer pixel can be acquired compared to the second embodiment.

In an APD element, in general, as the field intensity between a semiconductor region to which the cathode contact is connected (first semiconductor region 311) and a semiconductor region to which the anode contact is connected (ninth semiconductor region 319) increases, the noise degrades. Accordingly, in the second embodiment, when the voltage difference between the anode and the cathode is fixed, the noise degrades as the distance between the anode contact and the cathode contact reduces. That is, there is a trade-off between the acquisition of a finer pixel and the noise. In contrast, according to the present embodiment, the ninth semiconductor region 319 provided on the surface facing the light incident surface is eliminated by providing the anode contact on the light incident surface side, Thus, there is no trade-off relationship between the acquisition of the finer pixel and the noise.

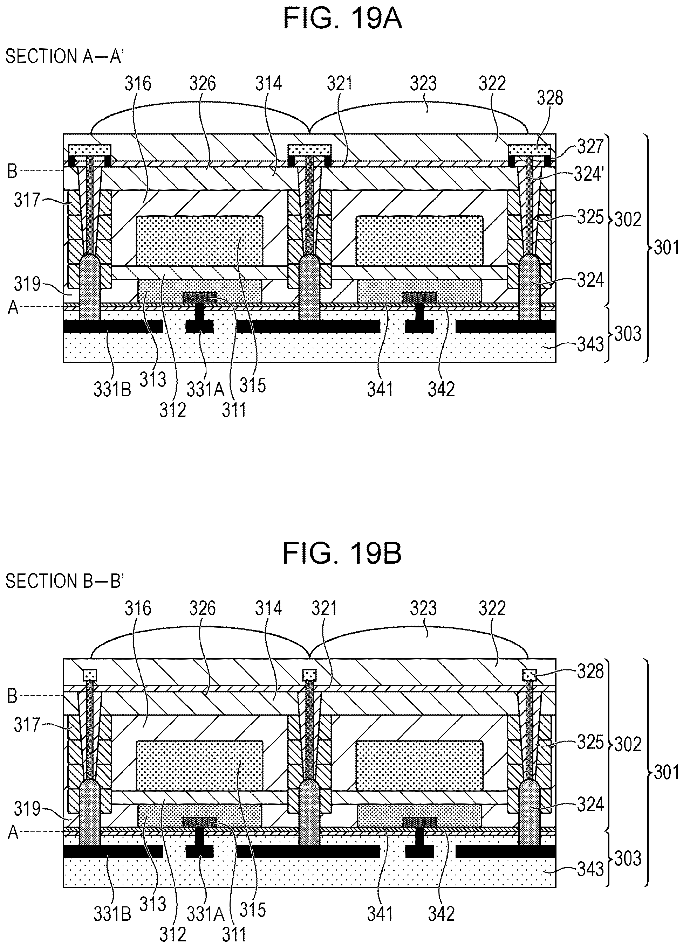

The anode potential supplied to the rear surface wiring may be supplied from a pad disposed on the light incident surface side. The rear surface wiring may be connected to the anode wiring 331B through the Si substrate in a pixel peripheral portion. As illustrated in Figs. 19A and 19B, the anode wiring 331B and the rear surface wiring may be connected in the pixel region via the isolation portions 324 and 325.

Figs. 19A and 19B are sectional views illustrating an example of a modification of the present embodiment. Figs. 19A and 19B illustrate an example in which, as described above, the anode potential supplied to the rear surface wiring is disposed via the anode wiring 331B and the isolation portions 324 and 325 in the pixel region. An advantage of this structure is that the potential can be stably supplied to the rear surface wiring 328 and the anode contact 327. When the potential is supplied from the pixel peripheral portion by using the rear surface wiring 328, wiring resistance or the like may cause voltage drop in a pixel central portion with respect to the pixel peripheral portion. This may cause degradation of image quality such as shading. In contrast, with this structure, the anode wiring 331B and the isolation portion 324 are connected to each other on a pixel-by-pixel basis and the wiring resistance can be reduced. Thus, voltage drop can be suppressed.

A method for manufacturing the photoelectric conversion device according to the fourth embodiment is described. The description of Figs. 12A to 13A, which is common for the method for manufacturing according to the second embodiment and the fourth embodiment, is omitted. However, as described above, the ninth semiconductor region 319 is not formed according to the present embodiment.

In the method for manufacturing after the formation illustrated in Fig. 13A, when processes such as deposition, photolithography, and etching are repeatedly performed, the anode contact 327, the rear surface wiring 328, the fixed electric charge film 321, the planarizing layer 322, and the microlens 323 are formed.

### (Fifth Embodiment)

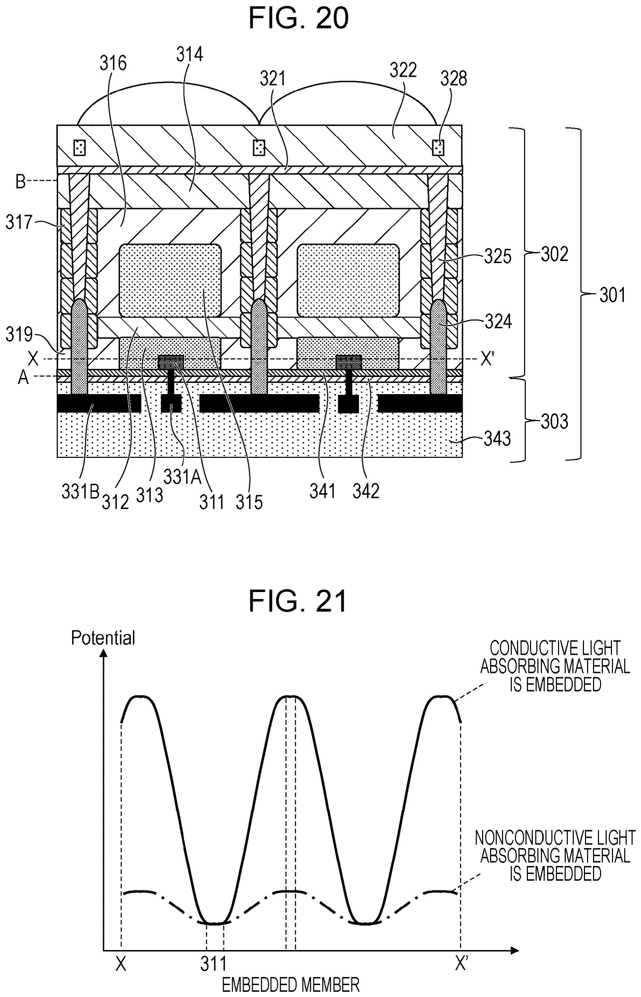

A photoelectric conversion device according to a fifth embodiment is described with reference to Figs. 20 and 21. The common description for the first to fourth embodiments and the fifth embodiment is omitted, and items different from those of the second embodiment are mainly described.

Fig. 20 is a sectional view of two pixels of the photoelectric conversion elements 102 of the photoelectric conversion device according to the fifth embodiment in the direction perpendicular to the planar direction of the substrate. Fig. 20 corresponds to section B-B' illustrated in Fig. 11. As is the case with the photoelectric conversion device described in the fourth embodiment, the rear surface wiring 328 is provided on the front surface side of the substrate.

According to the above-described embodiment, a conductive light absorbing material such as tungsten is embedded in the first isolation portion 324. As a characteristic of the present embodiment, a nonconductive light absorbing material is embedded in the first isolation portion 324. Examples of the nonconductive semiconductor material absorbing light emission include, for example, SiGe, Ge, GeSn, PbS, PbSe, PbTe, InGaAs, InAs, InSb, GaSb, HgCdTe, BiTe, SnTe, SnSe, and AgSe. That is, a material with a smaller band gap than that of Si. For suppressing an electrostatic influence on the semiconductor region forming the photoelectric conversion element 102, it is preferable that the semiconductor material embedded in the first isolation portion 324 be likely to be depleted. That is, an intrinsic semiconductor with a sufficiently low dopant concentration is preferred. A monocrystal, a polycrystal, or an amorphous may be used.

Examples of the nonconductive light absorbing material absorbing light emission include, for example, graphite, graphene, fullerene, carbon nanotube, FeOx, TiOx, MnOx, AgFexOy, VOx, LaBx, WOx, and NiPx.

Each of these is a material with a high absorption coefficient for visible light to near-infrared light.

Alternatively, an organic material, a quantum dot, a nanowire, a meta-surface, a plasmonic nanoparticle, a moth-eye structure, or the like may be embedded in the first isolation portion 324.

Fig. 21 is a diagram illustrating the potential in the photoelectric conversion device with the horizontal axis representing the position in the x direction in section X-X' illustrated in Fig. 20 and the vertical axis representing the potential. Variation of the potential in the photoelectric conversion device depending on the material embedded in the first isolation portion 324 is described with reference to Fig. 21.

When a conductive material is embedded in the first isolation portion 324, section X-X' of Fig. 20 indicates a potential distribution in which the potential is the highest in the first isolation portion and steeply inclined toward the first semiconductor region 311 where the potential is the lowest. Also when a nonconductive material is embedded in the first isolation portion 324, the potential is the highest in the first isolation portion and the lowest in the first semiconductor region 311. However, compared to the case where the conductive material is used for the embedding, the highest value of the potential is smaller and a milder potential gradient is formed. When such a potential gradient is formed, an effect of easing electric field concentration generated in the transverse direction (surface direction) of the pixel is acquired. That is, according to the present embodiment, both reduction of light emission crosstalk and easing of the electric field in the transverse direction can be achieved.

### (Sixth Embodiment)

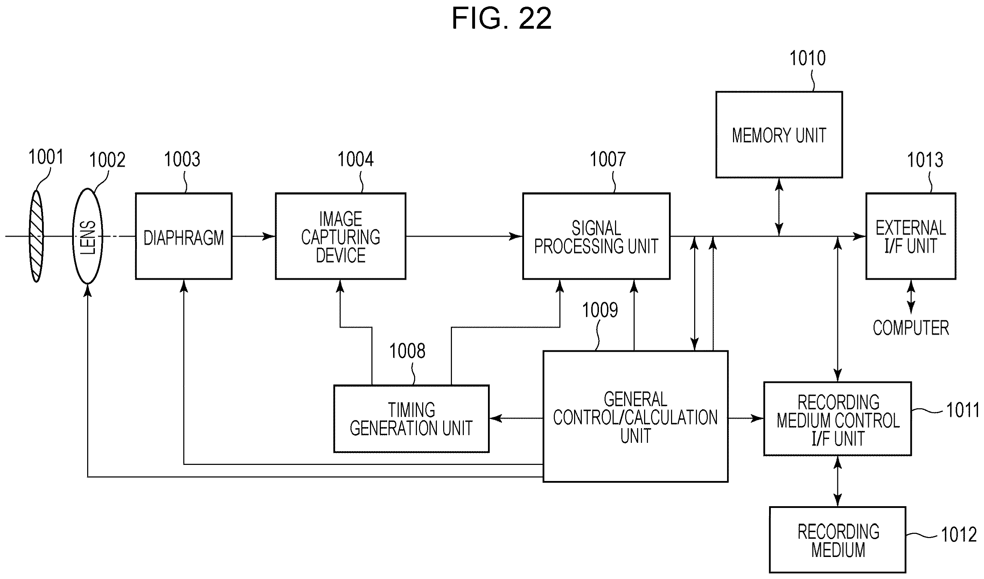

A photoelectric conversion system according to a sixth embodiment is described with reference to Fig. 22. Fig. 22 is a schematic block diagram illustrating the configuration of the photoelectric conversion system according to the present embodiment.

The photoelectric conversion device described in the first to fifth embodiments can be applied to various photoelectric conversion systems. Examples of the photoelectric conversion systems to which the photoelectric conversion device can be applied include digital still cameras, digital camcorders, surveillance cameras, copiers, facsimile machines, mobile phones, on-vehicle cameras, observation satellites, and so forth. A camera module that includes an optical system such as a lens and the image capturing device is also included in the photoelectric conversion system. Fig. 20 exemplifies a block diagram of a digital still camera as an example of these.

The photoelectric conversion system exemplified in Fig. 22 includes an image capturing device 1004 as an example of the photoelectric conversion device and a lens 1002 configured to form an optical image of an object in the image capturing device 1004. The photoelectric conversion system also includes a diaphragm 1003 for allowing variation of a light quantity passing through the lens 1002 and a barrier 1001 for protecting the lens 1002. The lens 1002 and the diaphragm 1003 are an optical system that concentrates the light to the image capturing device 1004. The image capturing device 1004 is the photoelectric conversion device according to any of the above-described embodiments and converts the optical image formed by the lens 1002 into an electric signal.

The photoelectric conversion system also includes a signal processing unit 1007 being an image generation unit configured to generate an image by processing an output signal output from the image capturing device 1004. The signal processing unit 1007 operates to output image data while performing various compensations and compression as required. The signal processing unit 1007 may be formed on a semiconductor substrate in which the image capturing device 1004 is provided or on a different semiconductor substrate from the semiconductor substrate in which the image capturing device 1004 is provided.

The photoelectric conversion system further includes a memory unit 1010 for temporarily storing the image data and an external interface unit (external I/F unit) 1013 for communicating with external computer and the like. The photoelectric conversion system further includes a recording medium 1012 such as semiconductor memory for recording or reading image capturing data and a recording medium control interface unit (recording medium control I/F unit) 1011 for recording in or reading from the recording medium 1012. The recording medium 1012 may be incorporated in the photoelectric conversion system or detachably attached to the photoelectric conversion system.

The photoelectric conversion system further includes a general control/calculation unit 1009 configured to control various calculations and the entirety of the digital still camera and a timing generation unit 1008 configured to output various timing signals to the image capturing device 1004 and the signal processing unit 1007. Here, a timing signal or the like may be input from the outside, and it is sufficient that the photoelectric conversion system at least include the image capturing device 1004 and the signal processing unit 1007 configured to process the output signal output from the image capturing device 1004.

The image capturing device 1004 outputs the image capturing signal to the signal processing unit 1007. The signal processing unit 1007 performs predetermined signal processing on the image capturing signal output from the image capturing device 1004 and outputs the image data. The signal processing unit 1007 generates an image by using the image capturing signal.

As described above, according to the present embodiment, the photoelectric conversion system to which the photoelectric conversion device (image capturing device) according to any of the above-described embodiments is applied can be realized.

### (Seventh Embodiment)

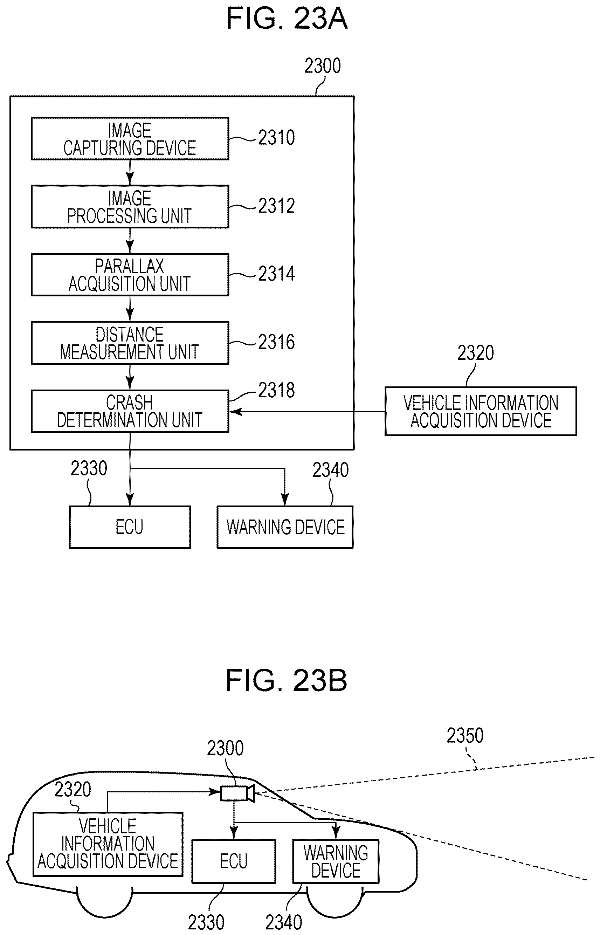

A photoelectric conversion system and a moving body according to a seventh embodiment are described with reference to Figs. 23A and 23B. Figs. 23A and 23B respectively illustrate a configuration of the photoelectric conversion system and a configuration of the moving body according to the present embodiment.

Fig. 23A illustrates an example of the photoelectric conversion system related to an on-vehicle camera. A photoelectric conversion system 1300 includes an image capturing device 1310. The image capturing device 1310 is the photoelectric conversion device (image capturing device) according to any of the above-described embodiments. The photoelectric conversion system 1300 includes an image processing unit 1312 and a parallax acquisition unit 1314. The image processing unit 1312 is configured to perform image processing on a plurality of pieces of image data acquired by the image capturing device 1310. The parallax acquisition unit 1314 is configured to calculate a parallax (a phase difference between parallax images) from the plurality of pieces of image data acquired by the photoelectric conversion system 1300. The photoelectric conversion system 1300 also includes a distance acquisition unit 1316 and a crash determination unit 1318. The distance acquisition unit 1316 is configured to calculate the distance to an object based on the calculated parallax. The crash determination unit 1318 is configured to determine whether a possibility of a crash exists based on the calculated distance. Here, the parallax acquisition unit 1314 and the distance acquisition unit 1316 are examples of a distance information acquisition unit configured to acquire information on the distance to the object. That is, the distance information is information related to, for example, the parallax, the amount of defocusing, and the distance to the object. The crash determination unit 1318 may use any of these pieces of the distance information to determine the possibility of a crash. The distance information acquisition unit may be realized by using solely designed hardware or a software module.

Alternatively, the distance information acquisition unit may be realized by using a field programmable gate array (FPGA), an application specific integrated circuit (ASIC), or the like or may be realized by using a combination of these.

The photoelectric conversion system 1300, which is connected to a vehicle information acquisition device 1320, can acquire vehicle information such as, for example, a vehicle speed, a yaw rate, and a rudder angle. The photoelectric conversion system 1300 is also connected to an electronic control unit (ECU) 1330 being a control unit configured to output a control signal generating a braking force for a vehicle based on a determination result with the crash determination unit 1318. The photoelectric conversion system 1300 also connected to a warning device 1340 configured to warn a driver based on the determination result with the crash determination unit 1318. For example, when the possibility of a crash is high based on the determination result with the crash determination unit 1318, the ECU 1330 brakes, throttles back, suppresses engine output, or perform other operation to control vehicle for avoiding a crash or reducing damage. The warning device 1340 warns a user by, for example, giving warning with a sound or the like, displaying warning information on a screen of a car navigation system or the like, or applying vibration to a seatbelt or a steering wheel.

According to the present embodiment, an image of a region around the vehicle, for example, a front region or a rear region is captured by the photoelectric conversion system 1300. Fig. 23B illustrates the photoelectric conversion system when the photoelectric conversion system captures an image of a front region of the vehicle (image capturing range 1350). The vehicle information acquisition device 1320 transmits an instruction to the photoelectric conversion system 1300 or the image capturing device 1310. With such a configuration, accuracy of measuring the distance can be improved.

Although the example of the control for avoiding a crash with another vehicle has been explained in the above description, the configuration described above can be applied to control of automatic driving following another vehicle, control of automatic driving so as not to move out of a lane, and the like. Furthermore, the photoelectric conversion system can be applied not only to the vehicle such as an automobile but also to, for example, a moving body (moving device) such as a ship, an aircraft, or an industrial robot. In addition, the photoelectric conversion system can be applied not only to the moving body but also widely to apparatuses that utilize object recognition such as an intelligent transportation system (ITS) and the like.

### (Eighth Embodiment)

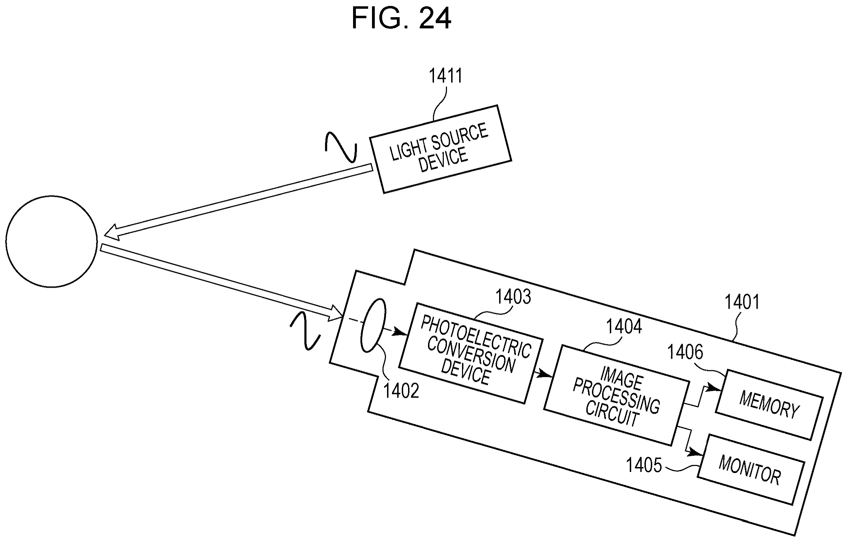

A photoelectric conversion system according to an eighth embodiment is described with reference to Fig. 24. Fig. 24 is a block diagram illustrating an example of the configuration of a distance image sensor being the photoelectric conversion system according to the present embodiment.

As illustrated in Fig. 24, a distance image sensor 401 includes an optical system 407, a photoelectric conversion device 408, an image processing circuit 404, a monitor 405, and memory 406. The distance image sensor 401 can acquire a distance image corresponding to the distance to an object by receiving light (modulation light or pulsed light) radiated from a light source device 409 toward the object and reflected by the surface of the object.

The optical system 407 includes a single lens or a plurality of lenses. The optical system 407 guides image light (incident light) from the object to the photoelectric conversion device 408 and forms the image on a light receiving surface (sensor unit) of the photoelectric conversion device 408.

The photoelectric conversion device according to each of the above-described embodiments is applied as the photoelectric conversion device 408. A distance signal indicating a distance acquired from a reception light signal output from the photoelectric conversion device 408 is supplied to the image processing circuit 404.

The image processing circuit 404 performs image processing to form the distance image based on the distance signal supplied from the photoelectric conversion device 408. The distance image (image data) acquired by the image processing is supplied to and displayed on the monitor 405 or supplied to and stored (recorded) in the memory 406.

The distance image sensor 401 configured as described above can acquire, for example, a more exact distance image as the pixel characteristics improve when the above-described photoelectric conversion device is applied.

### (Ninth Embodiment)

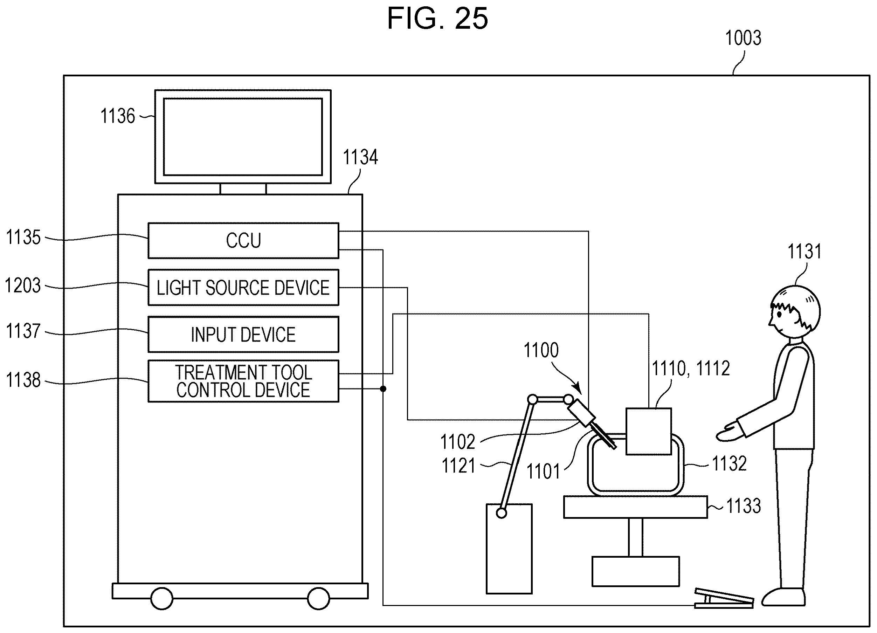

A photoelectric conversion system according to a ninth embodiment is described with reference to Fig. 25. Fig. 25 illustrates an example of a general configuration of an endoscope operation system being the photoelectric conversion system according to the present embodiment.

Fig. 25 illustrates a situation in which an operator (doctor) 1131 operates on a patient 1132 on a patient bed 1133 with an endoscope operation system 1150. As illustrated in Fig. 25, the endoscope operation system 1150 includes an endoscope 1100, operation tools 1110, and a cart 1134 on which various devices for the endoscope operation are mounted.

The endoscope 1100 includes a lens barrel 1101 and a camera head 1102. The lens barrel 1101 has a region of a predetermined length from the tip, and this region is inserted into a body cavity of the patient 1132. The camera head 1102 is connected to a base end of the lens barrel 1101. In the illustrated example, the endoscope 1100 is a so-called rigid scope including the rigid lens barrel 1101. However, the endoscope 1100 may be a so-called flexible scope including a flexible lens barrel.

The lens barrel 1101 has an opening at its tip. An objective lens is fitted into this opening. A light source device 1203 is connected to the endoscope 1100. Light generated by the light source device 1203 is guided to the tip of the lens barrel by using a light guide extending in the lens barrel 1101 and radiated toward an observation object in the body cavity of the patient 1132 via the objective lens. The endoscope 1100 may be a direct view endoscope, an oblique endoscope, or a lateral endoscope.

An optical system and the photoelectric conversion device are provided in the camera head 1102. The reflected light (observation light) from the observation object is collected to the photoelectric conversion device by the optical system. The observation light undergoes photoelectric conversion by using the photoelectric conversion device, and an electric signal corresponding to the observation light, that is, an image signal corresponding to the observation image is generated. As the photoelectric conversion device, the photoelectric conversion device according to each of the above-described embodiments can be used. The image signal is transmitted to a camera control unit (CCU) 1135 as raw data.

The CCU 1135 includes a central processing unit (CPU) or a graphics processing unit (GPU). The CCU 1135 is configured to perform centralized control on operation of the endoscope 1100 and a display device 1136. Furthermore, the CCU 1135 receives the image signal from the camera head 1102 and performs on this image signal various types of image processing for displaying an image based on the image signal such as, for example, a developing process (demosaicing process).

The display device 1136 displays, under the control of the CCU 1135, the image based on the image signal for which the image processing is performed by the CCU 1135.

The light source device 1203 includes light sources such as, for example, light emitting diodes (LEDs) and supplies irradiation light to the endoscope 1100 when an image of an operation target part or the like is captured.

An input device 1137 is an input interface for the endoscope operation system 1150. The user can input various types of information and instructions to the endoscope operation system 1150 via the input device 1137.

A treatment tool control device 1138 is configured to control drive of an energy treatment tool 1112 for ablation of the tissue, incision, sealing of a blood vessel, or the like.

The light source device 1203, which supplies to the endoscope 1100 the irradiation light for capturing the image of the operation target part, can include a white light source including, for example, LEDs, laser light sources, or a combination of these. When the white light source includes a combination of RGB laser light sources, output intensity and output timing of each color (each wavelength) can be accurately controlled. Thus, white balance of the captured image can be adjusted in the light source device 1203. Also in this case, images respectively corresponding to RGB can be captured in a time-division manner by radiating laser light from the RGB laser light sources to the observation object in a time-division manner and controlling drive of an image capturing element of the camera head 1102 in synchronization with the radiation timing. With this method, a color image can be acquired without providing a color filter in the image capturing element.

Drive of the light source device 1203 may be controlled so as to vary the intensity of output light every predetermined period of time. When the drive of the image capturing element of the camera head 1102 is controlled in synchronization with timing of the variation of light intensity to acquire images in a time-division manner and the acquired images are synthesized, an image of a high dynamic range without so-called blocked up shadows or blown out highlights can be generated.

Furthermore, the light source device 1203 may be able to supply light at a predetermined wavelength band corresponding to special light observation. The special light observation utilizes, for example, wavelength dependency of light absorption in the tissue of the body. Specifically, light of a narrow band compared to the irradiation light in a normal observation (that is, white light) is radiated so as to capture an image of a predetermined tissue such as a blood vessel in superficial portion of the mucous membrane at high contrast.

Alternatively, in the special light observation, fluorescent observation which acquires an image by using fluorescence generated due to radiation of the excitation light may be performed. The fluorescent observation allows, for example, observation of fluorescence from the tissue of the body by radiating the excitation light to the tissue of the body, or allows acquisition of a fluorescent image by locally injecting a reagent such as indocyanine green (ICG) into the tissue of the body and irradiating the tissue of the body with the excitation light corresponding to the fluorescent wavelength of the reagent. The light source device 1203 can be configured to supply narrow-band light and/or excitation light corresponding to the special light observation as described above.

### (Tenth Embodiment)

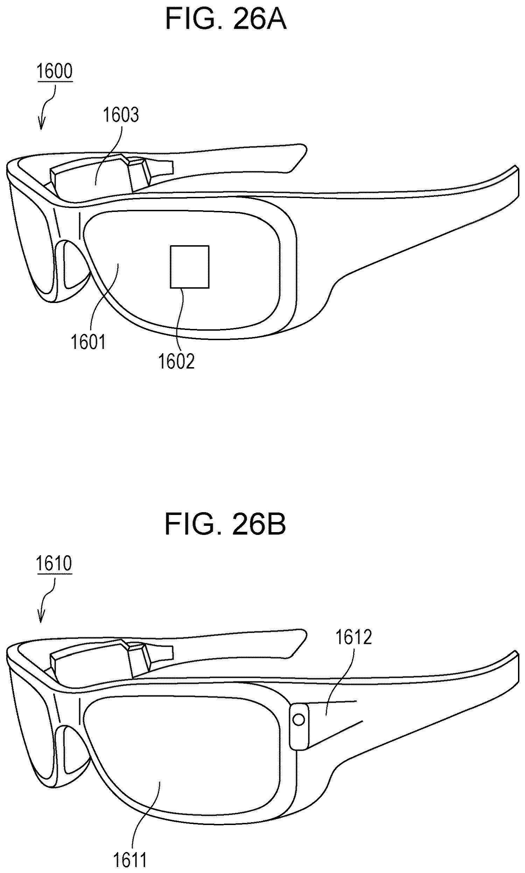

A photoelectric conversion system according to a tenth embodiment is described with reference to Figs. 26A and 26B. Fig. 26A illustrates a pair of glasses 1600 (smart glasses) being the photoelectric conversion system according to the present embodiment. The pair of glasses 1600 include a photoelectric conversion device 1602. The photoelectric conversion device 1602 is the photoelectric conversion device according to each of the above-described embodiments. Furthermore, a display device including a light emitting device such as an organic light-emitting diode (OLED) or an LED may be provided on a rear surface side of a lens 1601. A single photoelectric conversion device 1602 may be provided, or a plurality of photoelectric conversion device 1602 may be provided. Furthermore, a combination of a plurality of types of the photoelectric conversion devices may be used. The position where the photoelectric conversion device 1602 is disposed is not limited to the position illustrated in Fig. 26A.

The pair of glasses 1600 further includes a control device 1603. The control device 1603 functions as a power source that supplies power to the photoelectric conversion device 1602 and the above-described display device. Furthermore, the control device 1603 controls operation of the photoelectric conversion device 1602 and the display device. An optical system for concentrating the light to the photoelectric conversion device 1602 is formed in the lens 1601.

Fig. 26B illustrates a pair of glasses 1610 (smart glasses) according to an application example. The pair of glasses 1610 include a control device 1612. A photoelectric conversion device corresponding to the photoelectric conversion device 1602 and a display device are placed in the control device 1612. An optical system for projecting the light emitted from the photoelectric conversion device and the display device in the control device 1612 is formed in a lens 1611. Thus, an image is projected onto the lens 1611. The control device 1612 functions as a power source that supplies power to the photoelectric conversion device and the display device. In addition, the control device 1612 controls operation of the photoelectric conversion device and the display device. The control device may include a line-of-sight detection unit configured to detect a line of sight of a wearer. Infrared radiation may be used for the detection of the line of sight. An infrared emitter emits infrared rays toward an eyeball of the user who gazes a displayed image. Reflected light of the emitted infrared rays from the eyeball is detected by an image capturing unit including a light receiving element. Thus, a captured image of the eyeball can be acquired. A reduction unit configured to reduce the light from the infrared emitter to a display unit in plan view is provided. Thus, degradation of the quality of the image is reduced.

The line of sight of the user to the displayed image is detected from the captured image of the eyeball acquired by capturing the infrared rays. Any known technique can be applied to the detection of the line of sight by using the captured image of the eyeball. As an example, a method for detecting a line of sight based on a Purkinje image due to reflection of irradiation light at a cornea can be used.

More specifically, a line-of-sight detection process based on a pupil center corneal reflection method is performed. When a line-of-sight vector representing the direction of the eyeball (rotational angle) is calculated based on the Purkinje image and a pupil image included in the captured image of the eyeball by using the pupil center corneal reflection method, the line-of-sight of the user is detected.

The display device according to the present embodiment may include the photoelectric conversion device including the light receiving element and control a display image of the display device based on the line-of-sight information of the user from the photoelectric conversion device.

Specifically, for the display device, a first sight region gazed by the user and a second sight region other than the first sight region are determined based on the line-of-sight information. The first sight region and the second sight region may be determined by the control device of the display device. Alternatively, the display device may receive the first sight region and the second sight region determined by an external control device. In a display region of the display device, a display resolution of the first sight region may be controlled to be higher than a display resolution of the second sight region. That is, the resolution of the second sight region may be set to be lower than the resolution of the first sight region.

Furthermore, the display region may have a first display region and a second display region different from the first display region. Based on the line-of-sight information, a region to which a higher priority is given may be determined from the first display region and the second display region. The first sight region and the second sight region may be determined by the control device of the display device. Alternatively, the display device may receive the first sight region and the second sight region determined by an external control device. The resolution of the region of the higher priority may be controlled to be higher than the resolution of a region other than the region of the higher priority. That is, the resolution of a region of a relatively low priority may be reduced.

In determining the first sight region and the region of the high priority, artificial intelligence (AI) may be used. The Al may be a model configured to use, as training data, an image of the eyeball and the direction actually gazed by the eyeball of the image so as to estimate the angle of the line of sight and the distance to an object ahead of the line of sight from an image of the eyeball. An Al program may be included in the display device, the photoelectric conversion device, or the external device. When the Al program is included in the external device, the determination by the Al is transmitted to the display device via communication.

When the display is controlled based on visually recognized detection, the Al is preferably able to be applied to smart glasses that further include the photoelectric conversion device that captures external images. The smart glasses can display captured external information in real time.

### [Modifications]

The present invention is not limited to the above-described embodiment but can be modified in various manners.

For example, the embodiments of the present invention include an example in which a subset of configurations of any of the embodiments is added to another embodiment or replaced with a subset of configurations of another embodiment.

The photoelectric conversion system described in the above-described sixth and seventh embodiments is an example of the photoelectric conversion system to which the photoelectric conversion device can be applied. The photoelectric conversion system to which the photoelectric conversion device of the present invention can be applied is not limited to the configurations illustrated in Figs. 22, 26A, and 26B. This is also applicable to the ToF system described in the eighth embodiment, the endoscope described in the ninth embodiment, and the smart glasses described in the tenth embodiment.

Any of the above-described embodiments represents only examples of embodiments in carrying out the present invention, and the technical scope of the present invention shall not be limitedly interpreted by these. That is, the present invention can be carried out in various forms without departing from the technical concepts or the main features thereof.

The present invention is not limited to the above-described embodiments and can be changed and modified in a various manner without departing from the gist and scope of the present invention. Accordingly, in order to make the scope of the present invention public, the following claims are attached.

This application claims the priority based on Japanese Patent Application No. 2023-028686 filed February 27, 2023 and No. 2023-211925 filed December 15, 2023, which are hereby incorporated by reference herein in their entirety.

### Reference Signs List

100 photoelectric conversion device
201 avalanche diode
311 first semiconductor region
312 second semiconductor region
313 third semiconductor region
324 first isolation portion
325 second isolation portion

## Claims

1. A photoelectric conversion device comprising:
a semiconductor layer having a first surface and a second surface facing the first surface, the semiconductor layer including a plurality of avalanche photodiodes,
wherein the plurality of avalanche photodiodes include a first avalanche photodiode and a second avalanche photodiode,
wherein the first avalanche photodiode and the second avalanche photodiode each include a first semiconductor region of a first conductivity type and a second semiconductor region of a second conductivity type, the first semiconductor region and the second semiconductor region being arranged in this order from a second surface side, a PN bonding portion being formed between the first semiconductor region and the second semiconductor region,
wherein a first isolation portion and a second isolation portion are provided between the first avalanche photodiode and the second avalanche photodiode, the first isolation portion being formed from the second surface side, a light absorbing material being embedded in the first isolation portion, and the second isolation portion being formed from a first surface side, an insulating reflective member being embedded in the second isolation portion, and
wherein the first isolation portion penetrates through the second semiconductor region.

2. The photoelectric conversion device according to claim 1,
wherein, when a distance from a center of the first semiconductor region to a side wall of the first isolation portion in the PN bonding portion is A, a distance in a vertical direction from the PN bonding portion to a point where the first isolation portion and the second isolation portion are in contact with each other is B, a refractive index of silicon included in the semiconductor layer is n1, and a refractive index of the reflective member is n2, B ≥ A × tan{asin(n2/n1)} is satisfied.

3. The photoelectric conversion device according to claim 1, wherein the plurality of avalanche photodiodes further include a third avalanche photodiode,
wherein a third isolation portion and a fourth isolation portion are provided between the first avalanche photodiode and the third avalanche photodiode, the third isolation portion being formed from the second surface side, a light absorbing material being embedded in the third isolation portion, the fourth isolation portion being formed from the first surface side, an insulating reflective member being embedded in the fourth isolation portion, and
wherein, when a distance from a side wall of the first isolation portion to a side wall of the third isolation portion in a third surface on the first surface side in the first semiconductor region is 2A, a distance in a vertical direction from the third surface to a point where the first isolation portion and the second isolation portion are in contact with each other is B, a refractive index of silicon included in the semiconductor layer is n1, and a refractive index of the reflective member is n2, B ≥ A × tan{asin(n2/n1)} is satisfied.

4. The photoelectric conversion device according to claim 1, wherein, in a section perpendicular to the first surface, a thickness of the first isolation portion is greater than a thickness of the second isolation portion at a position where the first isolation portion and the second isolation portion are in contact with each other.

5. The photoelectric conversion device according to claim 1, wherein a bottom portion of the first isolation portion has an arc shape.

6. The photoelectric conversion device according to claim 1, wherein, in plan view, an area of the first semiconductor region is smaller than an area of the second semiconductor region.

7. The photoelectric conversion device according to claim 6,
wherein, in plan view, the first semiconductor region is contained in the second semiconductor region.

8. The photoelectric conversion device according to claim 1, wherein, in plan view, an area of wiring electrically connected to the first semiconductor region is smaller than an area of wiring electrically connected to the second semiconductor region.

9. The photoelectric conversion device according to claim 1, further comprising: a third semiconductor region of the first conductivity type between the first surface and the second semiconductor region.

10. The photoelectric conversion device according to claim 9, wherein the first isolation portion reaches the third semiconductor region.

11. The photoelectric conversion device according to claim 1, wherein the semiconductor layer has an uneven structure in the first surface.

12. The photoelectric conversion device according to claim 1, wherein the light absorbing material has conductivity.

13. The photoelectric conversion device according to claim 12,
wherein the light absorbing material mainly includes tungsten.

14. The photoelectric conversion device according to claim 12, wherein the light absorbing material is covered with an insulating film.

15. The photoelectric conversion device according to claim 1, wherein the light absorbing material is nonconductive.

16. The photoelectric conversion device according to claim 1, wherein a bandgap of the light absorbing material is smaller than a band gap of silicon included in the semiconductor layer.

17. The photoelectric conversion device according to claim 1, wherein at least part of the first isolation portion or the second isolation portion has a forward tapered shape.

18. The photoelectric conversion device according to claim 1, wherein the second isolation portion extends to the first surface.

19. The photoelectric conversion device according to claim 1, wherein the first isolation portion extends to wiring electrically connected to the second semiconductor region.

20. The photoelectric conversion device according to claim 1, further comprising:
wiring disposed on the first surface side.

21. The photoelectric conversion device according to claim 20, further comprising:
a contact disposed on the first surface side, the contact being electrically connected to the second semiconductor region.

22. A photoelectric conversion system comprising:
the photoelectric conversion device according to claim 1; and a signal processing unit configured to generate an image by using a signal output by the photoelectric conversion device.

23. A moving body comprising:
the photoelectric conversion device according to claim 1; and a control unit configured to control movement of the moving body by using a signal output by the photoelectric conversion device.
